# EUROPEAN PATENT SPECIFICATION

(11) **EP 3 163 669 B1**
(45) Date of publication and mention of the grant of the patent: **30.10.2019**
(21) Application number: 15811538.6
(22) Date of filing: 24.02.2015
(51) Int. Cl.: H01M 10/48, G01R 31/36, G06N 3/00, H01M 10/42, H01M 10/44, H02J 7/00, H03M 7/30, G05B 13/02

(54) **DEGRADATION CONTROL DEVICE OF STORAGE BATTERY SYSTEM AND METHOD FOR SAME**
ABNUTZUNGSKONTROLLVORRICHTUNG EINES SPEICHERBATTERIESYSTEMS UND VERFAHREN DAFÜR
DISPOSITIF DE CONTRÔLE DE DÉGRADATION DE SYSTÈME DE BATTERIE DE STOCKAGE ET PROCÉDÉ POUR CELUI-CI

(30) Priority: 24.06.2014 JP 2014129699
(43) Date of publication of application: 03.05.2017
(73) Proprietor: Kabushiki Kaisha Toshiba, Minato-ku Tokyo 105-8001 (JP)
(72) Inventor: WADA, Takahisa, Tokyo 105-8001 (JP); KUBOTA, Kazuto, Tokyo 105-8001 (JP); MIZUTANI, Mami, Tokyo 105-8001 (JP); KUBOTA, Masayuki, Tokyo 105-8001 (JP)
(74) Representative: AWA Sweden AB
(86) International application number: PCT/JP2015/055154
(87) International publication number: WO 2015/198631

(56) References cited:
- EP-A1- 2 325 664
- JP-A- H08 136 629
- JP-A- 2004 101 188
- JP-A- 2007 205 878
- JP-A- 2013 044 598
- JP-A- 2013 115 863
- US-A1- 2012 121 952

## Description

### TECHNICAL FIELD

Embodiments of the present disclosure relate to a deterioration control device of a battery system and a method thereof.

### BACKGROUND ART

In battery systems that have a large number of battery cells, actual measured values of the battery cell, such as the voltage value, the temperature value, and the SOC (remaining battery level) value, are monitored to control the system. Exemplary control devices incorporated in the battery system are a deterioration control device and a charging-and-discharging control device. The deterioration control device has an important role such as estimating the deterioration state of the system based on the actual measured values.

US2012/121952 A1 discloses a battery status detecting device and battery pack where the battery status detecting device is provided.

Data of the actual measured values of the battery cell is normally handled as utilization record data, and stored in a memory to construct a database. According to deterioration control devices for the battery system, an amount of data of a deterioration model parameter is calculated from the utilization record data of when the battery cell is charged and discharged, and a deterioration model to estimate the deterioration state is constructed.

The deterioration model parameter is an element that indicates the deterioration state of the battery cell, and is, for example, the temperature value or the SOC value. For example, an amount of data indicating how long the battery cell remained at a certain temperature value and at a certain SOC value is calculated, and the deterioration model for the temperature value and for the SOC value is constructed. That is, the amount of data on the deterioration model parameter is the amount of deterioration on the battery system per a unit time, and is capable of indicating the deterioration rate of the battery system. By integrating this deterioration rate data by time, the deterioration state of the battery system can be estimated.

As explained above, deterioration control devices estimate the deterioration state of the battery system based on the constructed deterioration model, and output the estimation result to charging-and-discharging control devices. Charging-and-discharging control devices create a charging and discharging schedule, and the utilization pattern of the batteries based on the obtained estimation result from deterioration control devices. In addition, charging-and-discharging control devices control charging and discharging of the battery cell in accordance with these charging and discharging schedule and utilization pattern. At this time, by considering the predicted demand amount and the predicted PV power generation amount, etc., into consideration, the minimization of electricity rate and the maximization of the battery lifetime are achieved.

Patent documents 1-9, etc., disclose various conventional technologies proposed for the deterioration control devices of the battery systems. Patent document 1 discloses a technology of determining the possibility of the battery lifetime reduction based on the utilization record data on the batteries, and prompting a charging as needed. In addition, patent document 2 discloses measuring a duration time and a temperature of the highly charged state of the batteries, creating a table from predetermined data, and calculating the deterioration coefficient of the batteries referring to this table.

Patent documents 3, 4, etc., disclose technologies of estimating the deterioration state of the batteries. According to patent document 3, a least square scheme, etc., is applied to the battery utilization record data to perform a linear approximation, and the impedance is calculated to estimate the deterioration state of the batteries. According to patent document 4, a reference value map is created based on the power and the temperature, the calculated value from this reference value map is compared with a measured internal resistance value to update the reference value map, and the deterioration state of the batteries is estimated.

In addition, by using a large number of utilization record data, the accuracy of the deterioration control can be improved. For example, instead of processing the utilization record data only by the local system side of the battery system, the battery system may be constructed by a server side like a cloud computing system, and the local system side, and the server side may be interlinked with the local system side. According to such battery system, since it becomes possible to provide a large memory, an increase in the amount of utilization record data becomes compatible. Patent documents 5-7, etc., disclose deterioration control devices proposed for such battery system.

According to patent document 5, the utilization record data on the batteries is transmitted from the local side to the server side via a communication, and the server side calculates a lifetime consumption value for each local system. Next, the calculation result is transmitted to the local system side, and the deterioration control is performed for each local system.

According to patent document 6, a charger to which the batteries are attached is connected to the server, the utilization record data on the batteries is obtained from the charger and is transmitted to the server to construct the database of the utilization record data, and a deterioration diagnosis is performed on the batteries. According to patent document 7, the utilization record data on the batteries is recorded in the database via a network, and a deterioration diagnosis is performed on the batteries using the database.

In addition, conventionally proposed are patent document 8 that collects the utilization record data on the batteries to analyze a defect reason, and patent document 9 which collects the utilization record data in an on-line scheme to analyze the data, and determines the utilization environment of the batteries and the lifetime for each battery.

Those technologies are to evaluate the deterioration state of the battery, but as for the deterioration state of the battery, the evaluation result remarkably differs when the evaluation is made in a laboratory and when the evaluation is made under an actual utilization condition. This includes a technical problem like the sensor accuracy, etc., for measuring the utilization record data, and a deterioration evaluation under an actual utilization condition is desired.

### CITATION LIST

### PATENT LITERATURES

Patent Document 1: JP H08-140205 A
Patent Document 2: JP 2004-222427 A
Patent Document 3: JP 2006-250905 A
Patent Document 4: JP 2002-754617 A
Patent Document 5: JP 2012-60833 A
Patent Document 6: JP 2008-83022 A
Patent Document 7: JP 2007-141464 A
Patent Document 8: JP 2003-17138 A
Patent Document 9: JP 2003-123847 A

### SUMMARY OF INVENTION

### TECHNICAL PROBLEM

However, conventional deterioration control devices of the battery system have the following technical problems.

### (First Problem) Compatibility for Diversified Applications of Battery System

In recent years, battery systems are utilized in various sites, such as a general household, a building, and a transformer substation. Hence, depending on the application of the battery system, the charging and discharging current value at the utilization site varies, and the available capacity changes for each application.

More specifically, in the case of a small-scale battery system like a general household application, the C rate becomes small, and in the case of a large-scale battery system that is a combination with, for example, wind power generation, the C rate becomes large. In the field of battery systems, there is a tendency that the application is diversifying as explained above. Therfore, there is a desire for battery-system-deterioration control devices to more flexibly and accurately create the deterioration model.

### (Second Problem) Reduction of Data Amount Used for Deterioration Control

In battery systems, the utilization record data of the battery cell is stored in the memory, but the number of battery cells provided for a single battery system is a quite large number, for example several thousands to several ten thousands. In addition, when a single server is to comprehensively manage a large number of battery systems, the memory provided to the server side needs to store a remarkably large amount of utilization record data. Thus, the amount of utilization record data is quite large, and the load to the memory that needs to store those data is quite large.

Still further, when the measurement cycle of the utilization record data is shortened in order to improve the accuracy of the deterioration control on the battery system, the amount of data further becomes large. Hence, there is a desire for deterioration control devices of the battery system to reduce the amount of utilization record data for the deterioration control without not at all reducing the deterioration control accuracy at all.

### (Third Problem) Construction of Deterioration Model by Data Obtained from Entire Battery System

In battery systems, the timing at which the utilization record data on the battery cell is obtained is generally a time at which the system maintenance is performed, and also a time at which a refresh charging and discharging at a regular interval is performed.

The refresh charging and discharging is to charge up to 100 % after the capacity value of the battery system is reduced to 0 % or to discharge down to 0 % after the capacity value of the battery system is increased to 100 % in order to reset the capacity value or to measure the actual capacity value. Data obtained at the time of refresh charging and discharging is from the entire battery system. Hence, the amount of data for the deterioration model parameter calculated based on such data is the amount of data on the entire battery system.

The data on the entire battery system may sometimes does not precisely reflect the deterioration state of each battery cell. For example, the amount of data on the deterioration model parameter varies depending on a case in which the deterioration state of each battery cell is uniform or similar, and a case in which the deterioration state differs battery cell by battery cell. This is because the amount of data on the entire battery system varies depending on the variability in deterioration state of each battery cell.

In addition, this variability is not irreversible but temporal, and it has been pointed out that the amount of data is unstable for estimating the real deterioration state of the battery system. Hence, when the data obtained from the entire battery system is used, a deterioration control device which is capable of eliminating the effect of the variability in deterioration state of each battery cell, and of constructing a highly precise deterioration model, is desired.

Embodiments of the present disclosure have been proposed in order to address the aforementioned technical problems, and an objective is to provide a deterioration control device of the battery system and a method thereof, which are compatible to the diversification of an application by precisely learning a necessary deterioration model for a deterioration control, , are capable of reducing the amount of data to be utilized for the deterioration control, and are capable of constructing a highly precise deterioration model even if data obtained from the entire battery system is utilized.

### SOLUTION TO PROBLEM

In order to achieve the above objective, embodiments of the present disclosure relate to a deterioration control device for a battery system including a plurality of battery cells, and the deterioration control device includes following structural components (a) to (c):
(a) a utilization-record-data obtaining block obtaining utilization record data of the battery cell;
(b) a learning block updating an amount of data of a deterioration model parameter that indicates a deterioration state of the battery cell based on the utilization record data, learning the deterioration model parameter, and outputting a learnt result that is a deterioration rate table; and
(c) a learning instruction block comparing the utilization record data with an estimation value, determining whether or not the deterioration model parameter is learnt, and outputting a learning instruction signal to the learning block, while at the same time calculating a change amount in the deterioration model parameter for the battery cell, and outputting the change amount to the learning block.

Furthermore, the learning block includes following structural components (d) to (f):
(d) a constant-current-capacity calculating unit calculating a constant-current capacity value obtained by charging or discharging until a specific voltage at a constant current;
(e) a constant-voltage-capacity calculating unit performing again the charging or the discharging until a constant voltage at a reduced constant current after the battery cell is charged or discharged until the constant voltage at a constant current, repeating a step-by-step decrease in current value and charging or discharging until reaching the constant voltage, integrating capacity values up to a time point at which the current value becomes sufficiently small, and calculating a constant-voltage capacity value; and
(f) a current-capacity set calculating unit calculating a set of the current value when the constant-voltage capacity value is obtained and the constant-voltage capacity value.

In addition, a deterioration controlling method for the battery system is also an aspect of the embodiments of the present disclosure.

### BRIEF DESCRIPTION OF DRAWINGS

FIG. 1 is an entire structural diagram according to a first embodiment;
FIG. 2 is a diagram illustrating an example deterioration rate table;
FIG. 3 is a structural diagram illustrating a learning block according to the first embodiment;
FIG. 4 illustrates an example of capacity value table and internal resistance value table that are a deterioration rate table;
FIG. 5 is a graph illustrating a similarity evaluation based on the deterioration rate table;
FIG. 6 is a graph for dividing the deterioration rate table into three types;
FIG. 7 is a graph for dividing the deterioration rate table into two types;
FIG. 8 is a flowchart according to the first embodiment;
FIG. 9 is a structural diagram for a learning block according to a second embodiment;
FIG. 10 is a flowchart according to the second embodiment;
FIG. 11 is a structural diagram for a utilization-record-data obtaining block according to a third embodiment;
FIG. 12 is a table illustrating an example code term for entropy encoding according to the third embodiment;
FIG. 13 is a flowchart according to the third embodiment;
FIG. 14 is a structural diagram for a utilization-record-data obtaining block according to a fourth embodiment;
FIG. 15 is a flowchart according to the fourth embodiment;
FIG. 16 is a structural diagram for a utilization-record-data obtaining block according to a fifth embodiment;
FIG. 17 is a structural diagram for a utilization-record-data obtaining block according to a sixth embodiment;
FIG. 18 is a flowchart according to the sixth embodiment;
FIG. 19 is a structural diagram for a learning instruction block according to a seventh embodiment;
FIG. 20 is a graph for explaining the learning instruction block according to the seventh embodiment;
FIG. 21 is a flowchart according to the seventh embodiment;

### DESCRIPTION OF EMBODIMENTS

### Entire Structure of Battery System

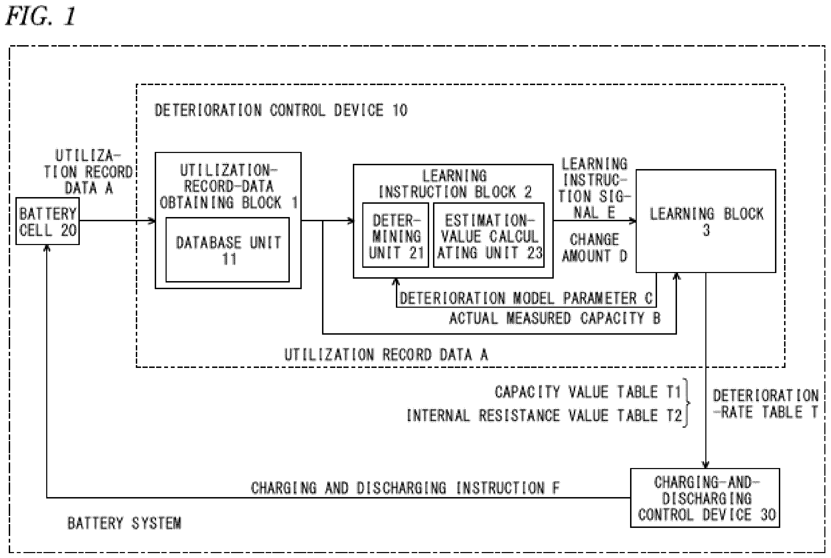

An explanation will be given of an entire structure according to an embodiment of the present disclosure with reference to FIG. 1. A battery system is provided with a plurality of battery cells 20. The battery cell 20 outputs utilization record data A to a deterioration control device 10. Exemplary utilization record data A are the voltage value, temperature value, current value, and SOC value of the battery cell 20.

The deterioration control device 10 is connected to each battery cell 20. The deterioration control device 10 is connected to a charging-and-discharging control device 30. The charging-and-discharging control device 30 creates a charging and discharging schedule, and a utilization pattern of batteries based on an estimation result by the deterioration control device 10, and controls charging and discharging by the battery cell 20.

As for controlling the charging and discharging of the battery cell 20, the charging-and-discharging control device 30 obtains a charging and discharging instruction F from the charging and discharging schedule and the utilization pattern, and outputs the obtained instruction to the battery cell 20. The battery cell 20 that has received the charging and discharging instruction F from the charging-and-discharging control device 30 performs charging and discharging in accordance with the charging and discharging instruction F.

### (2) Outline of Deterioration Control Device

The deterioration control device 10 gets the utilization record data A input from each battery cell 20, creates a deterioration rate table T, and estimates the deterioration state of the battery cell 20. The deterioration control device 10 outputs the estimation result for the deterioration state of the battery cell 20 to the charging-and-discharging control device 30. The deterioration control device 10 mainly includes three large blocks. The three blocks are a utilization-record-data obtaining block 1, a learning instruction block 2, and a learning block 3. Respective outlines of the utilization-record-data obtaining block 1, the learning instruction block 2, and the learning block 3 will be explained below.

### [Utilization-record-data obtaining block]

The utilization-record-data obtaining block 1 gets the utilization record data A input from each battery cell 20, and outputs the utilization record data A to the learning instruction block 2 and the learning block 3. The utilization-record-data obtaining block 1 is provided with a database 11. The database 11 stores the utilization record data A in a lossless compression. The utilization-record-data obtaining block 1 decompresses the compressed utilization record data A stored in the database 11, and reads the decompressed data.

### [Learning instruction block]

The learning instruction block 2 includes a determining unit 21, and an estimation-value calculating unit 23. The determining unit 21 reads the utilization record data A from the utilization-record-data obtaining block 1, and reads both an actual measured capacity B and a deterioration model parameter C from the learning block 3, compares those information to determine whether or not to learn the deterioration rate table T, and outputs a learning instruction signal E. Note that the deterioration model parameter C is an element that indicates the deterioration state of the battery cell 20 as explained in the paragraph [0004], and is the temperature value, the SOC value, etc. In addition, the actual measured capacity B, and the deterioration rate table T will be explained in the following paragraphs [0035], [0033], respectively. Still further, when the determining unit 21 determines to learn the deterioration rate table T, the determining unit 21 outputs the learning instruction signal E to the learning block 3.

When the determining unit 21 determines to learn the deterioration rate table T, the estimation-value calculating unit 23 calculates a change amount D in the deterioration model parameter C, and outputs the calculated amount to the learning block 3. The change amount D in the deterioration model parameter C is an estimation value for the capacity deterioration amount (in general, expressed as %) per a battery cell 20.

### [Learning Block]

The learning block 3 transmits the actual measured capacity B and the deterioration model parameter C to the learning instruction block 2. In addition, the learning block 3 receives the change amount D in the deterioration model parameter C and the learning instruction signal E from the learning instruction block 2, updates the amount of data on the deterioration model parameter C, learns the deterioration model parameter, and outputs the deterioration rate table T to the charging-and-discharging control device 30.

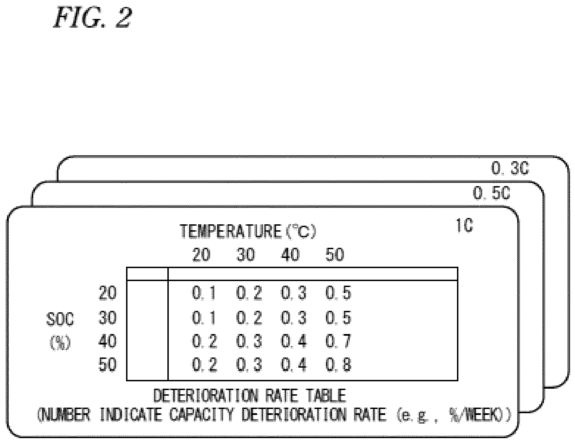

The deterioration rate table T is a collection of data on the deterioration model parameter C as the learnt result by the learning block 3 in a table format, and is a group of data that indicates the deterioration rate of the battery system. FIG. 2 illustrates an example deterioration rate table T. As illustrated in FIG. 2, exemplary deterioration tables T are a table that shows the deterioration rate of the capacity value in the battery system per a week under a condition in which the SOC value of the battery at 1 ° C is 50 %, 40 %, 30 %, 20 %, etc., and the temperature value is 20 °C, 30 °C, 40 °C, 50 °C, etc., and, a table that shows the deterioration rate of the capacity value in the battery system per a week under the same condition at 0.5 ° C.

### (3) First Embodiment

### [Structure]

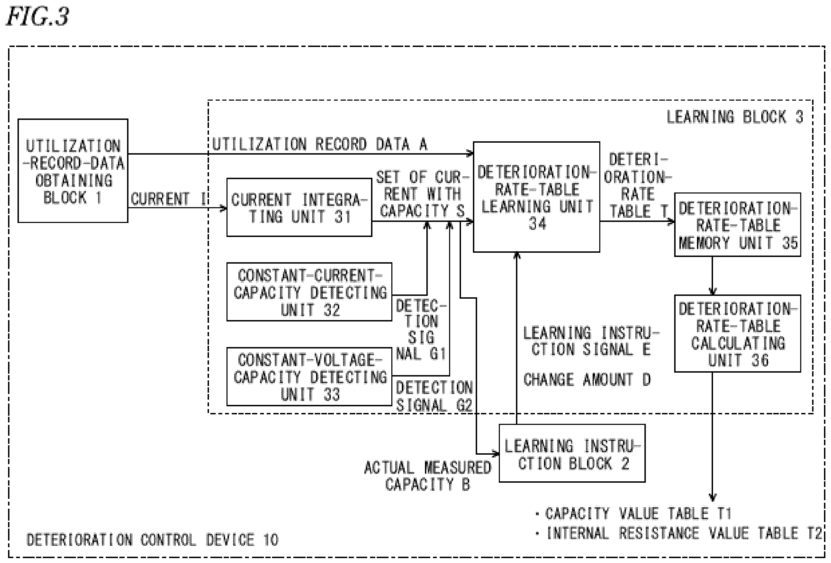

According to a first embodiment, the learning block 3 among the three blocks in the deterioration control device 10 has characteristic structures. As illustrated in FIG. 3, the learning block 3 includes a current integrating unit 31, a constant-current-capacity detecting unit 32, a constant-voltage-capacity detecting unit 33, and a deterioration-rate-table learning unit 34. Among those units, the current integrating unit 31 calculates the actual measured capacity B in accordance with the utilization record data A from the utilization-record-data obtaining block 1 and detection signals G1, G2 from the detecting units 32, 33, and outputs the actual measured capacity B to the learning instruction block 2.

By combining the current integrating unit 31 and the constant-current-capacity detecting unit 32, a capacity at a constant current is calculated, and by combining the current integrating unit 31 and the constant-voltage-capacity detecting unit 33, a capacity at a constant voltage is calculated. The calculated actual measured capacity B by the current integrating unit 31 is a value obtained by utilizing two types of capacity value that are the constant-current capacity value and the constant-voltage capacity value. The constant-current capacity value and the constant-voltage capacity value are capacity values that depend on the measurement schemes, and those two capacities have different physical meanings.

The constant-current capacity value is a capacity value of when the battery is charged or discharged until a specific voltage at a constant current. Hence, the current integrating unit 31 receives the detection signal G1 that is the start signal and end signal of the charging or discharging from the constant-current-capacity detecting unit 32, and integrates the capacity values therebetween, and obtains the constant-current capacity value.

On the other hand, the constant-voltage capacity is a total capacity value of when the battery is charged or discharged until a constant voltage by reducing the charging or discharging current value step by step. That is, the current integrating unit 31 receives, at a constant current I1, the detection signal G2 that is the start signal and end signal of the charging or discharging from the constant-voltage-capacity detecting unit 33, and integrates capacity values x1 therebetween. Next, the current integrating unit 31 measures capacity values x2 of when the battery is charged or discharged until reaching the constant voltage again at a constant current 12 that is smaller than the constant current I1 (i.e., I1 > I2).

Subsequently, the current integrating unit 31 decreases the current value to measure step by step, and repeatedly measures capacity values xn until the current becomes a sufficiently small current value In, and thus the total of the capacity values (x1 + x2 + ... xn) becomes the constant-voltage capacity value. The current integrating unit 31 obtains the constant-current capacity value and the constant-voltage capacity value as explained above.

In addition to the actual measured capacity B, the current integrating unit 31 also outputs a set S of the current value and the capacity value to the deterioration-rate-table learning unit 34. The set S of the current value and the capacity value is data that is a set of an average current value at the time of charging or discharging when the constant-voltage capacity value is obtained, with the constant-voltage capacity value.

The deterioration-rate-table learning unit 34 is connected to the current integrating unit 31, and is also connected to the utilization-record-data obtaining block 1, and the learning instruction block 2. The deterioration-rate-table learning unit 34 gets the set S of the current value and the capacity value input from the current integrating unit 31, the utilization record data A input from the utilization-record-data obtaining block 1, and the change amount D and the learning instruction signal E from the learning instruction block 2, input. In addition, the deterioration-rate-table learning unit 34 outputs the deterioration model parameter C to the learning instruction block 2, and outputs the learnt deterioration rate table T to the charging-and-discharging control device 30.

The deterioration-rate-table learning unit 34 learns the deterioration rate table T in accordance with various input data. What the deterioration-rate-table learning unit 4 learns is the amount of data on the deterioration model parameter C on the deterioration rate table T. The term learn in this case is to update the amount of data on the deterioration model parameter C based on the change amount D. That is, the deterioration rate table T having the updated amount of data on the deterioration model parameter C is the learnt result by the learning block 3. The above learning process is achieved by optimization that utilizes heuristic algorithms, such as a genetic algorithm and an annealing scheme.

In the learning block 3, the deterioration-rate-table learning unit 34 is connected to a deterioration-rate-table memory unit 35, and the deterioration-rate-table memory unit 35 is connected to a deterioration-rate-table calculating unit 36. The deterioration-rate-table calculating unit 36 is connected to the charging-and-discharging control device 30. Among those units, the deterioration-rate-table memory unit 35 stores the deterioration rate table T calculated for each current value.

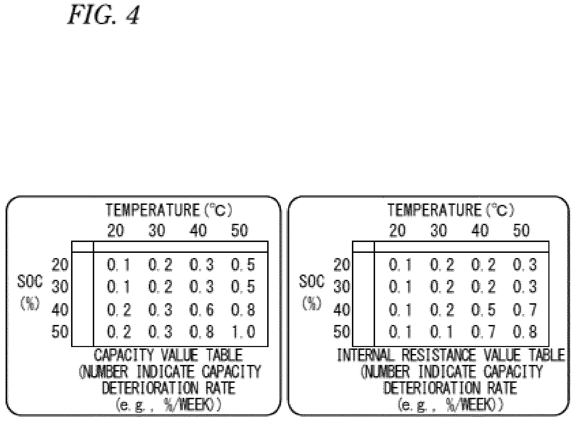

The deterioration-rate-table calculating unit 36 takes out the deterioration rate table T from the deterioration-rate-table memory unit 35, and calculates data contained in two types of deterioration rate tables. The two types of deterioration rate tables are a capacity value table T1 (left side in FIG. 4) calculated based on the constant-current capacity value, and an internal resistance value table T2 (right side in FIG. 4) calculated based on the constant-voltage capacity value.

The deterioration-rate-table calculating unit 36 compares the plurality of internal resistance value tables T2 with each other, and classifies the similarity between the tables T2 into a plurality of groups in accordance with a preset determination standard. More specifically, the deterioration-rate-table calculating unit 36 determines the similarity of the internal resistance value tables T2 for the SOC direction that has the SOC as a determination element, and for the temperature direction that has the temperature as a determination element, and classifies the determination result into groups.

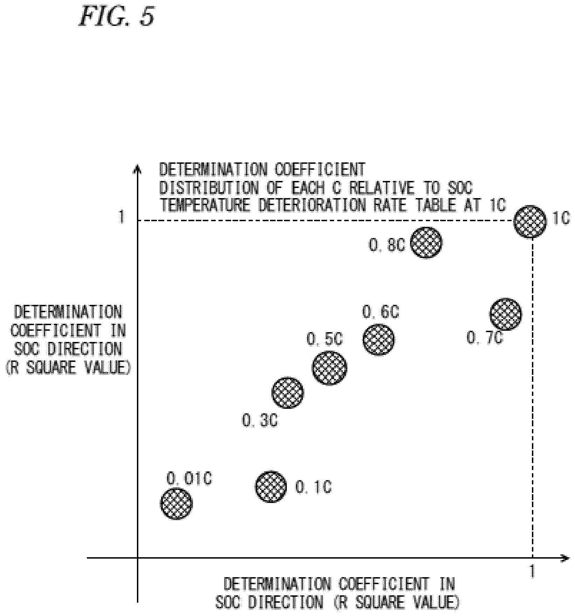

As for the determination on the similarity of the internal resistance value table T2, the deterioration-rate-table calculating unit 36 calculates respective determination coefficients (R squared) of the internal resistance value tables T2 for the SOC direction and the temperature direction of the capacity value table T1, and determines the similarity of the internal resistance value tables T2 based on the determination coefficients. This process will be illustrated in FIG. 5.

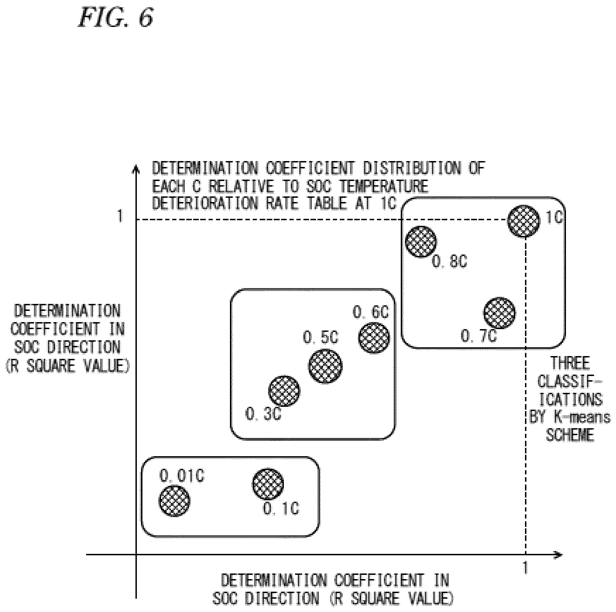

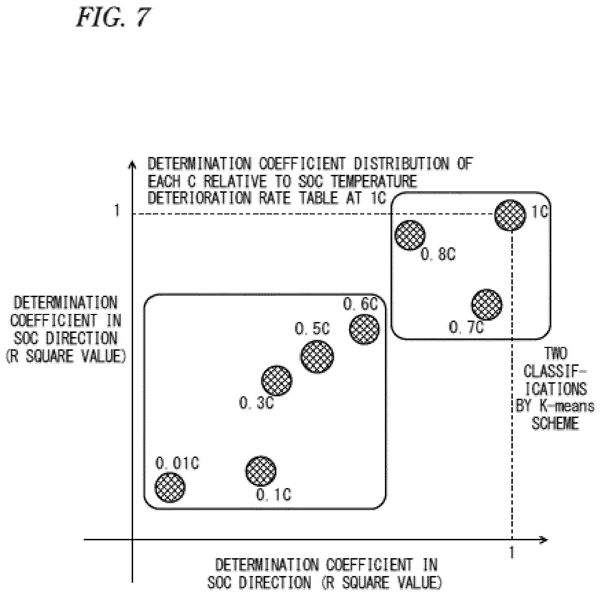

The number of classifications for the internal resistance value table T2 by the deterioration-rate-table calculating unit 36 can be set freely as appropriate, and the number of classifications may be automatically determined in accordance with a pre-set standard, or may be externally input by a user. The greater the number of classifications for the internal resistance value table T2 is, the finer the deterioration control is enabled in accordance with the current value. When, however, the number of classifications is too large, the calculation costs for the control increase. Hence, in view of the balance between the calculation costs and the control accuracy, the preferred number of classifications is set to, such as three as illustrated in FIG. 6 or two as illustrated in FIG. 7. The classification of the internal resistance value table T2 is executable by schemes like a k-means scheme.

In addition, when there are a plurality of internal resistance value tables T2 in the same group, the deterioration-rate-table calculating unit 36 outputs, to the charging-and-discharging control device 30, the internal resistance value table T2 that is the center of the group among the internal resistance value tables T2 in each group. The deterioration-rate-table calculating unit 36 also outputs, to the charging-and-discharging control device 30, the current value that is the threshold for each classification.

### [Learning Process]

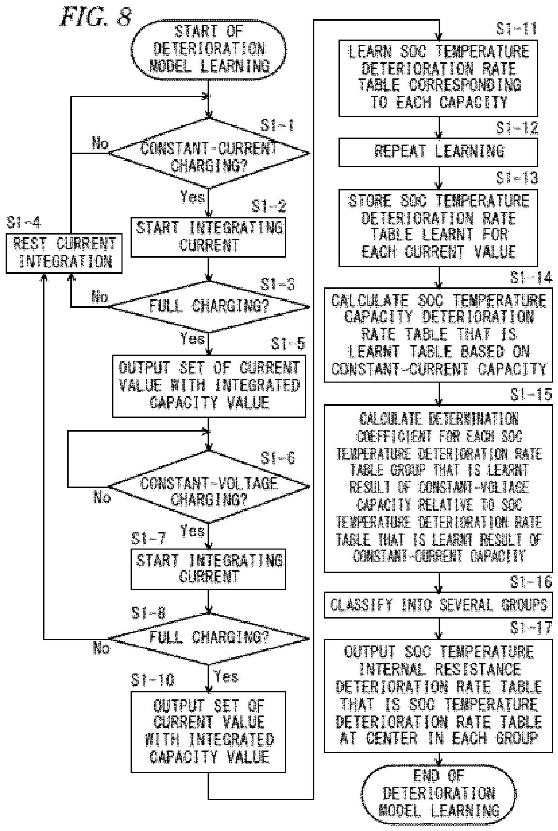

An explanation will be given of a learning process for the deterioration model by the learning block 3 with reference to the flowchart of FIG. 8. The utilization record data A is input from the utilization-record-data obtaining block 1 to the current integrating unit 31. The constant-current-capacity detecting unit 32 determines whether or not a charging at the constant current is started (S1-1). When the start of charging at the constant current is detected, the constant-current-capacity detecting unit 32 outputs the detection signal G1 to the current integrating unit 31 (S1-1: YES). Upon receiving this detection signal G1, the current integrating unit 31 starts integrating the currents (S1-2). When the start of charging at the constant current is not detected(S1-1: NO), the constant-current-capacity detecting unit 32 repeats the determination process on whether or not the charging at the constant current is started.

When the end of the charging at the constant current due to a full charging is detected, the constant-current-capacity detecting unit 32 outputs the detection signal G1 indicating the end of charging to the current integrating unit 31, and checks whether or not the battery cell 20 has been fully charged (S1-3). At this time, when the battery cell 20 has not been fully charged (S1-3: NO), the current integrating unit 36 stops the current integration, and resets the integrated value (S1-4). When the battery cell 20 has been fully charged (S1-3: YES), the current integrating unit 31 receives the detection signal G1 from the constant-current-capacity detecting unit 32, calculates the constant current capacity value, and outputs the set S of the current value with the capacity value to the deterioration-rate-table learning unit 34 (S1-5).

When the start of charging at the constant voltage is detected, the constant-voltage-capacity detecting unit 33 outputs the detection signal G2 to the current integrating unit 31 (S1-6: YES). This detection signal G2 starts the current integrating unit 31 to integrate the current integration (S1-7). When the start of charging at the constant voltage is not detected (S1-6: NO), the constant-current-capacity detecting unit 32 repeats the determination process on whether or not the charging at the constant voltage is started. When the end of charging at the constant voltage by a full charging is detected, the constant-voltage-capacity detecting unit 33 outputs the detection signal G2 to the current integrating unit 31 (S1-8). When it is not a full charging (S1-8: NO), the current integrating unit 31 stops the current integration, and resets the integrated value (S1-4).

When the battery cell 20 has been fully charged (S1-8: YES), the current integrating unit 31 receives the detection signal G2 from the constant-voltage-capacity detecting unit 33, and calculates a constant-voltage capacity value. Next, the current integrating unit 31 combines the capacity value and the average current value at the time of the charging or discharging at the constant voltage, and outputs the set S of the current value and the capacity value to the deterioration-rate-table learning unit 34 (S1-10).

The deterioration-rate-table learning unit 34 learns, in accordance with the set S of the current value and the capacity value output by the current integrating unit 31, the utilization record data A from the utilization-record-data obtaining block 1, and the learning instruction signal E and the change amount D from the learning instruction block 2, the deterioration rate table T in accordance with each capacity (S1-11). The learning on the estimation value in the deterioration rate table T is performed for each set S of the current value and the capacity value output by the current integrating unit 31, and is repeated for all sets S of the current value and the capacity value which the learning instruction signal E is added (S1-12). The deterioration-rate-table memory unit 35 stores the deterioration rate table T calculated for each current value (S1-13).

The deterioration-rate-table calculating unit 36 calculates the capacity value table T1 that is the deterioration rate table which is based on the constant-current capacity value (S1-14). In addition, the deterioration-rate-table calculating unit 36 calculates each determination coefficient (R squared) for the internal resistance value table T2 which is a learnt result of the constant-voltage capacity value relative to the capacity value table T1 that is the learnt result of the constant-current capacity value (S1-15). Furthermore, the deterioration-rate-table calculating unit 36 classifies the collection of the internal resistance value tables T2 obtained based on the constant-voltage capacity value into several groups (S1-16), and outputs, to the charging-and-discharging control device 30, only the internal resistance value table T2 at the center of each group (S1-17). The learning process of the deterioration model by the learning unit 3 ends as explained above.

Although it is not illustrated in FIG. 8, when the start of discharging at the constant current is detected, the constant-current-capacity detecting unit 32 outputs the detection signal to the current integrating unit 31, and this received detection signal makes the current integrating unit 31 to start integrating the current. Next, when the end of discharging at the constant current due to a complete discharging is detected, the constant-current-capacity detecting unit 32 outputs the detection signal indicating the end of discharging to the current integrating unit 31, and checks whether or not the battery cell 20 is fully discharged. At this time, when the battery cell 20 has not been fully discharged, the current integrating unit 31 stops the current integration, and resets the integrated value. When the battery cell has been fully discharged, the current integrating unit 31 receives the detection signal from the constant-current-capacity detecting unit 32, calculates the constant-current capacity value, and outputs the set S of the current value and the capacity value to the deterioration-rate-table learning unit 34.

When the start of discharging at the constant voltage is detected, the constant-voltage-capacity detecting unit 33 outputs the detection signal to the current integrating unit 31. This detection signal makes the current integrating unit 31 to start integrating the current. When the end of discharging at the constant voltage due to a complete discharging is detected, the constant-voltage-capacity detecting unit 33 outputs the detection signal to the current integrating unit 31. When it is not a complete discharging, the current integrating unit 31 stops the current integration, and resets the integrated value. When the battery cell 20 has been fully discharged, the current integrating unit 31 receives the detection signal from the constant-voltage-capacity detecting unit 33, and calculates the constant-voltage capacity value. Next, the current integrating unit 31 combines the average current value at the time of charging or discharging at the constant voltage with the capacity value, and outputs the set S of the current value and the capacity value to the deterioration-rate-table learning unit 34. As for the learning process by the deterioration-rate-table learning unit 34, it is the same as that of the case in which the charging starts.

### [Action and Effect]

The magnitude of the charging and discharging current value varies depending on the scale of the battery system, etc., but if it is necessary to estimate the state of the battery system using the same deterioration rate table T regardless of the charging and discharging that is performed slowly at the low charging and discharging current value or the charging and discharging that is performed promptly at the high charging and discharging current value, it is difficult to improve the accuracy of the deterioration control.

The capacity value of the battery system varies depending on the current value at the time of charging and discharging, and the amount of change by the current value depends on the deterioration amount of the internal resistance value. Hence, when the internal resistance value can stably be estimated, the accuracy of the deterioration control may be improved. Therefore, according to the first embodiment, the capacity value table T1 that is the learnt result of the constant-current capacity value is calculated, while at the same time, the internal resistance value is surely estimated using the internal resistance value table T2 obtained efficiently based on the capacity value table T1, and thus the improvement of the deterioration control accuracy is achieved. The learning block 3 according to the first embodiment utilizes the constant-current capacity value and the constant-voltage capacity value in order to output the capacity value table T1 and the internal resistance value table T2, as the learnt results. As explained above, since the constant-current capacity value is the capacity value of when the battery cell is charged or discharged until the specific voltage at the constant current, the measurement is simple, and the required time for this measurement is short.

However, the constant-current capacity value is affected not only by the deterioration in the capacity value of the battery system but also the deterioration of the internal resistance value in the battery system, and the capacity value changes. In addition, the internal resistance value of the battery system changes in accordance with the temperature, voltage value, current value and SOC value of the battery, and further the usage situation of the battery system. On the other hand, since the constant-voltage capacity value is measured while the current value at the time of charging or discharging is reduced step by step, the measurement takes a long time. However, the constant-voltage capacity value has advantages such that it is not likely to be affected by the deterioration of the internal resistance value.

Hence, according to the first embodiment, the capacity value table T1 that is the learnt result of the constant-current capacity value is compared with the internal resistance value table T2 that is the learnt result of the constant-voltage capacity value, and the effect of the deterioration of internal resistance value contained in the constant-current capacity value is obtained. That is, according to the first embodiment, the internal resistance value of the battery system which has been difficult to estimate according to conventional technologies can easily be estimated using the internal resistance value table T2, and thus the deterioration control is highly precisely performed on the battery system.

Meanwhile, when the constant-voltage capacity value is to be measured, it is necessary to measure the capacity values for a large number of current values, and the learning cycle for the internal resistance value table T2 becomes quite fast. Consequently, the amount of data for the estimation of the internal resistance value increases, and technical problems such as the control becoming complicated so that the measurement is likely to be affected by noises, etc., is expected.

In order to address the above technical problems, according to the learning block 3 in the first embodiment, the deterioration-rate-table learning unit 34 classifies the large number of deterioration rate tables T learnt based on the constant-voltage capacity value into several groups, and then only the table that is the center of each group is output as the internal resistance value table T2. This remarkably reduces the amount of data for the internal resistance value estimation. Hence, a simplified control is achieved, and the adverse effect like noises can be eliminated.

In addition, by the deterioration-rate-table learning unit 34 comparing the similarity of the tables with each other for the SOC direction and the temperature direction that directly indicate the deterioration state of the battery cell 20, since the internal resistance value tables T2 is classified into several groups, the classification work efficiently advances, enabling the prompt learning process. Still further, since the deterioration-rate-table learning unit 34 is capable of specifying the number of groups for the classification, the total number of internal resistance value tables T2 that are the learnt results can easily be adjusted.

Yet still further, the learning block 3 in the first embodiment calculates the set S of the current value and the capacity value , which the constant-voltage capacity value and the average current value of when the current integrating unit 31 obtains the constant-voltage capacity value are combined, and repeatedly learns all sets S of the current value and the capacity value subjected to the learning instruction signal E. This enables a fine learning, improving the deterioration control accuracy.

Moreover, the learning block 3 may distinctively learn the capacity value at the time of discharging and the capacity value at the time of charging in such learning process. This is because, theoretically, the capacity value at the time of discharging and the capacity value at the time of charging are not completely consistent with each other due to hysteresis, etc. Since whether of the capacity value in charging or in discharging can be stably measured depends on the material of electrode, etc, the learning block 3 distinctively learns the capacity value at the time of discharging and the capacity value at the time of charging based on the determination standard that is the electrode material, etc., and the estimation accuracy of the deterioration model is further improved. In addition, the learning block 3 may delete the utilization record data A held by the learning block 3 in accordance with the learning instruction signal E from the learning instruction block 2. Since this utilization record data A is unnecessary hereafter, the memory capacity can be saved by deleting such data.

### (4) Second Embodiment

### [Structure]

According to a second embodiment, the learning block 3 has characteristic features, like the first embodiment, and the basic structure is the same as that of the first embodiment. Hence, the same structural component as that of the first embodiment will be denoted by the same reference numeral, and the explanation thereof will be omitted. The learning block 3 in the first embodiment has all structural components provided at the local side.

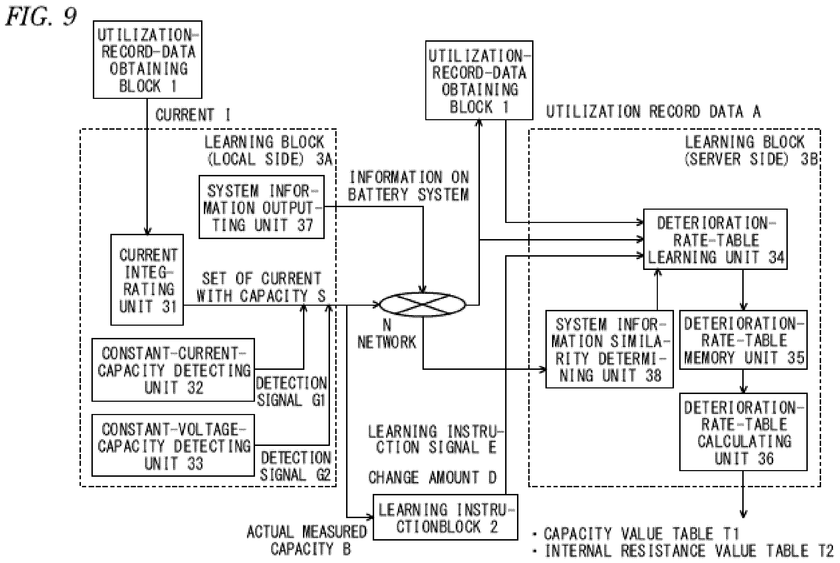

On the other hand, according to the second embodiment, although the learning block 3 employs the same structure, the location where the structural components are provided is divided into the local side of the battery system and the server side thereof. FIG. 9 illustrates such structure according to the second embodiment. As illustrated in FIG. 9, the learning block in the second embodiment is divided into a learning block 3A at the local side, and a learning block 3B at the server side.

The learning block 3A at the local side includes the current integrating unit 31, the constant-current-capacity detecting unit 32, the constant-voltage-capacity detecting unit 33, and a system information outputting unit 37. On the other hand, the learning block 3B at the server side includes the deterioration-rate-table learning unit 34, the deterioration-rate-table memory unit 35, the deterioration-rate-table calculating unit 36, and a system-information-similarity determining unit 38. The learning blocks 3A, 3B are connected to each other via the network N.

In addition, according to the second embodiment, the system information outputting unit 37 of the local-side learning block 3A transmits information about the battery system to the system-information-similarity determining unit 38 of the server-side learning block 3B. The system-information-similarity determining unit 38 collects information about the battery systems transmitted from the plurality of local-side learning blocks 3A, and determines whether the battery systems are the same type or similar types based on mutual informations. Exemplary information on the battery system are the manufacturer of the battery cell, the manufacturing lot, and environmental information on the battery system, i.e., the latitude and longitude of the location where the battery system is installed, the temperature and humidity around the system, and the present lifetime of the battery system.

### [Learning Process]

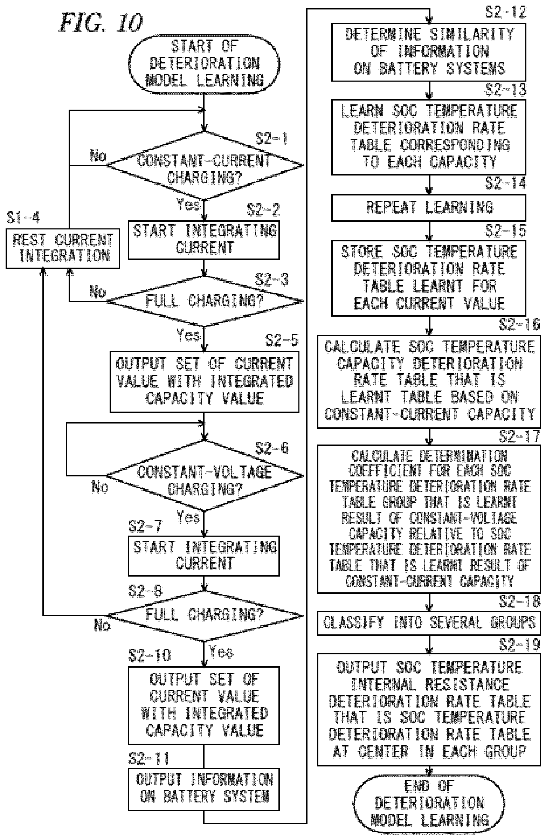

An explanation will be given of a learning process according to the second embodiment with reference to a flowchart that is FIG. 10. The learning process according to the second embodiment has the features such that steps S2-11, S2-12 are added to the above flowchart that is FIG. 8. Hence, the processes from S2-1 to S2-10 in FIG. 10 are the same as those from S1-1 to S1-10 in FIG. 8, and the processes from S2-13 to S2-19 in FIG. 10 are the same as those from S1-11 to S1-17 in FIG. 8.

In the learning process according to the second embodiment, the system information outputting unit 37 of the local-side learning block 3A transmits the information about the battery system to the server-side learning block 3B via the network N (S2-11). In the server-side learning block 3B, the system-information-similarity determining unit 38 receives the information about the battery system. The system-information-similarity determining unit 38 collects the plurality of information about the battery systems from the plurality of local-side learning blocks 3A. Next, the system-information-similarity determining unit 38 determines whether the information on the battery systems are the same or similar (S2-12).

Hence, in the learning steps (S2-13, S2-14) for the deterioration rate table T, when the system-information-similarity determining unit 38 determines that the information about the battery systems are the same or similar, the deterioration-rate-table learning unit 34 refers to the learnt result from the resemble battery system, enabling an efficient learning. This is because, in the server-side learning block 3B, when the information about the battery systems are determined as being the same or similar, a comparison between the similar information on the battery systems is more desirable as for the deterioration state.

### [Action and Effect]

According to the above second embodiment, even when the battery system cannot learn the details at the local side alone, the server-side learning block 3B collects the information about the battery systems, and determines and grasp the mutual similarity among the plurality of battery systems. This enables the learnt result at the other battery system with a high similarity to be available for reference. Consequently, at the server-side learning block 3B, the deterioration-rate-table learning unit 34 learns the various deterioration rate tables T, accelerating the learning speed, and improving the estimation accuracy. Thus, the deterioration control performance is further improved.

### (5) Third Embodiment

Following third to sixth embodiments have characteristic features in the structure of the utilization-record-data obtaining block 1. The utilization-record-data obtaining block 1 is one of the three blocks which are roughly divided in the deterioration control device 10. In the third to sixth embodiments, the structures other than the utilization-record-data obtaining block 1 is the same as those of the first embodiment, and the explanation thereof will be omitted.

### [Structure]

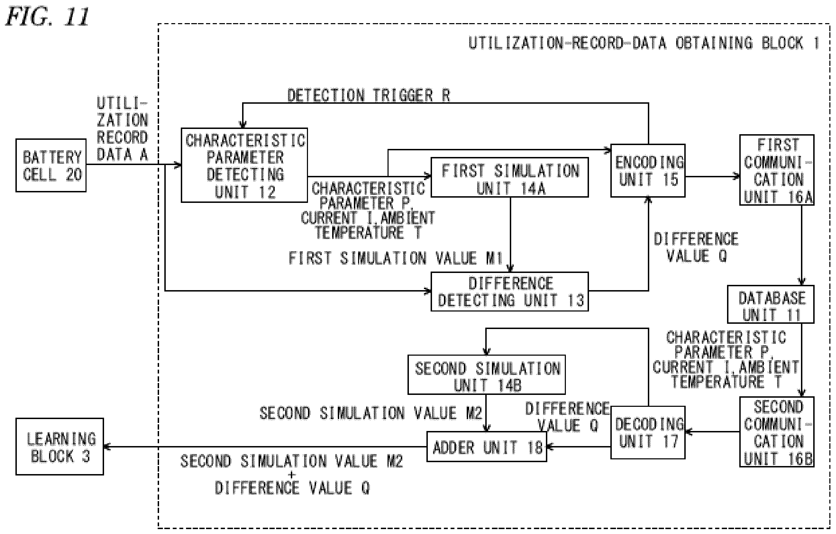

As illustrated in FIG. 11, the utilization-record-data obtaining block 1 according to the third embodiment includes, in addition to the database unit 11 explained in the paragraph [0029], a characteristic parameter detecting unit 12. The characteristic parameter detecting unit 12 is connected to a first simulation unit 14A and an encoding unit 15, and the first simulation unit 14A is connected to a difference detecting unit 13.

The difference detecting unit 13 is connected to the encoding unit 15, and the encoding unit 15 is connected to a first communication unit 16A, the database unit 11, a second communication unit 16B, and a decoding unit 17 in sequence. The decoding unit 17 is connected to an adder unit 18 and a second simulation unit 14B. In addition, the second simulation unit 14B is connected to the adder unit 18. Still further, the adder unit 18 is connected to the learning block 3.

Among those structural components of the above utilization-record-data obtaining block 1, the characteristic parameter detecting unit 12 has the utilization record data A input and analyzed, thereby detecting a characteristic parameter P for the battery cell 20. The characteristic parameter P for the battery cell 20 indicates the behavior of the battery cell 20, and is generally a time constant or an internal resistance. Exemplary internal resistances are a plurality of parameters, such as a DC-component internal resistance, an AC-component internal resistance, a charging-side internal resistance, and a discharging-side internal resistance. An explanation will be below given of an example method for the characteristic parameter detecting unit 12 to detect the characteristic parameter P.

Adopted methods are, for example, taking the utilization record data A from the battery cell 20 that is charging and discharging at random, and detecting the characteristic parameter P from that data, and utilizing a specific charging and discharging pattern, and detecting the characteristic parameter P based on that pattern. In this embodiment, an adopted method is taking the utilization record data A at the time of maintenance for the battery system or at the time of refresh charging and discharging executed at a constant cycle, and detecting the plurality of characteristic parameters P.

In addition, the characteristic parameter detecting unit 12 has a detection trigger R to be input from the encoding unit 15 when the amount of encoded data to be explained later becomes equal to or greater than a threshold, and detects again the characteristic parameter P. Still further, the characteristic parameter detecting unit 12 outputs, together with the detected characteristic parameter P, a current value I and an ambient temperature t of the battery cell 20 to the first simulation unit 14A and the encoding unit 15.

The first simulation unit 14A takes the current value I and the ambient temperature t of the battery cell 20, and further the characteristic parameter P from the characteristic parameter detecting unit 12, and simulates the deterioration state of the battery cell 20 based on those data. The first simulation unit 14A calculates a simulation result that is a first simulation value M1 containing the voltage value, the temperature value, and the SOC value, etc. The difference detecting unit 13 obtains the first simulation value M1 from the first simulation unit 14A, further obtains the utilization record data A from the battery cell 20, detects a difference value Q between the two data, and outputs the detected value to the encoding unit 15.

To the encoding unit 15. the current value I, the ambient temperature t, and the characteristic parameter P all from the characteristic parameter detecting unit 12, and the difference value Q from the difference detecting unit 13 are input, Those data are encoded, and output to the first communication unit 16A. In addition, the encoding unit 15 outputs the detection trigger R to the characteristic parameter detecting unit 12 when the amount of encoded data becomes equal to or greater than the threshold. Still further, the encoding unit 15 does not output the data when the data on the characteristic parameter P has the same details as that of the last data.

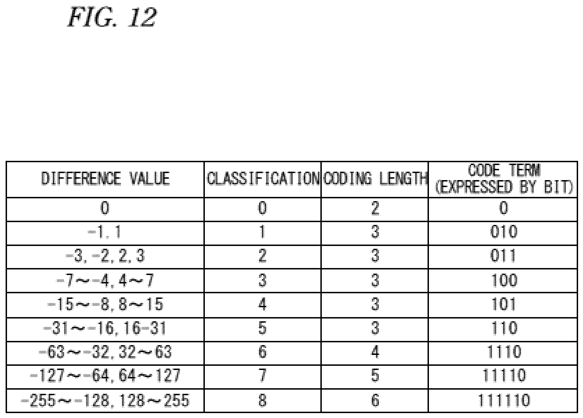

The encoding unit 15 performs entropy encoding like Huffman coding at the time of the encoding the difference value Q. When attempting to obtain the occurrence probability for each time, the amount of calculation becomes too large, and therefore as illustrated in the table in FIG. 12, the encoding unit 15 allocates a short coding length to a small value. That is, when the first simulation value M1 is close to the actual measured value like the utilization record data A, the encoding unit 15 allocates a short coding length. The applied code term table by the encoding unit 15 is also applied by the decoding unit 17.

Meanwhile, when the first simulation value M1 obtained by the first simulation unit 14A is close to the actual measured value, and when the short coding length is allocated, if the first simulation value M1 is a large value, the coding length remarkably increases, and the coding length may become shorter when the entropy encoding are not applied. Hence, when the first simulation value m1 is greater than a predetermined value, the encoding unit 15 does not perform entropy encoding but simply converts the value into a binary number.

The first communication unit 16A transmits the encoded data by the encoding unit 15 to the database unit 11. The database unit 11 stores the encoded data transmitted from the first communication unit 16A. The second communication unit 16B reads the data from the database unit 11, and transmits the read data to the decoding unit 17. The decoding unit 17 decodes the encoded data, such as the characteristic parameter Q, the current value I and the ambient temperature value t of the battery cell 20thereof, and further the difference value Q, and outputs the decoded data to the adder unit 18.

The second simulation unit 14B takes the characteristic parameter P, the current value I and the ambient temperature t of the battery cell 20, from the decoding unit 17, simulates the deterioration state of the battery cell 20, and outputs a second simulation value M2 to the adder unit 18. The adder unit 18 takes in the second simulation value M2 and the decoded difference value Q, adds those values, and outputs the addition result to the learning instruction block 2 and the learning block 3.

### [Data Process by Utilization-record-data Obtaining Block]

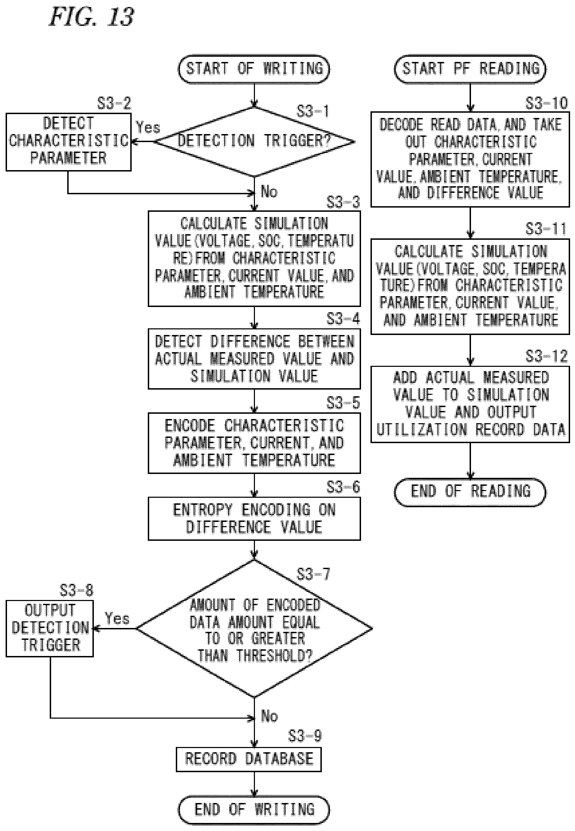

A data process according to the third embodiment will be explained with reference to the flowchart that is FIG. 13. First, a data writing process to the database unit 11 will be explained. First of all, the characteristic parameter detecting unit 12 determines whether or not there is the detection trigger R (S3-1).

When there is the detection trigger R (S3-1: YES), the characteristic parameter detecting unit 12 detects the characteristic parameter P as follow. First, the utilization record data A containing the voltage value, temperature value, current value, and SOC value, etc., of the battery cell is externally input to the characteristic parameter detecting unit 12, and the characteristic parameter detecting unit 12 detects the characteristic parameter P of the battery cell 20 by analyzing the input data (S3-2).

When there is no detection trigger R (S3-1: NO), the detection of the characteristic parameter P by the characteristic parameter detecting unit 12 is omitted, and the process progresses to step S3-3. In the step S3-3, the data that are the characteristic parameter P, the current value I and the ambient temperature t of the battery cell 20, are input to the first simulation unit 14A, and the first simulation unit 14A simulates the deterioration state of the battery cell 20 based on those data, and calculates the first simulation value M1 containing the voltage value, the temperature value, and the SOC value, etc. Next, the difference detecting unit 13 detects the difference between the utilization record data A and the first simulation value M1, and transmits the difference value Q to the encoding unit 15 (S3-4).

The encoding unit 15 encodes the characteristic parameter P, the current value I and the ambient temperature t of the battery cell 20 (S3-5). In order to reduce the amount of encoded data, however, the encoding unit 15 does not output the data on the characteristic parameter P that is the same as that of the last data. In addition, the encoding unit 15 performs entropy encoding on the difference value Q (S3-6).

The encoding unit 15 determines whether or not the amount of encoded data is equal to or greater than the threshold (S3-7). if the amount of encoded data increases in the encoding unit 15, this indicates that the simulation result is becoming apart from the actual measured value, i.e., that is, the value of the characteristic parameter P tends to becoming different from the actual value. Hence, when the amount of encoded data is equal to or greater than the threshold (S3-7: YES), the encoding unit 15 outputs the detection trigger R since the simulation result is becoming apart from the actual measured value, and makes the characteristic parameter detecting unit 12 to detect again the characteristic parameter P (S3-8). Subsequently, the database unit 11 records the encoded data from the encoding unit 15 (S3-9). In addition, when the amount of encoded data is smaller than the threshold (S3-7: NO), the encoding unit 15 does not output the detection trigger R, and the database unit 11 records the encoded data (S3-9).

Subsequently, an explanation will be given of a data reading process from the database unit 11. The second communication unit 16B outputs the read data from the database unit 11 to the decoding unit 17. The decoding unit 17 decodes the output data by the second communication unit 16B using the code term table utilized by the encoding unit 15.

The decoding unit 17 outputs the characteristic parameter P, the current I, and the ambient temperature t to the second simulation unit 14A, and outputs the difference value Q to the adder unit 18 (S3-10). Like the first simulation unit 14A, the second simulation unit 14B has the current value I and ambient temperature t input, simulates the deterioration state of the battery cell 20 using the characteristic parameter P, and outputs the second simulation value M2 containing the voltage value, the temperature value, and the SOC value, etc., to the adder unit 18 (S3-11).

The adder unit 18 adds the output simulation value M2 by the second simulation unit 14B and the output difference value Q by the decoding unit 17, and detects a conclusive value. This conclusive value will be the same as the utilization record data A, and this value is output to the learning instruction block 2 and the learning block 3 as the utilization record data A (S3-12).

### [Action and Effect]

According to the above third embodiment, when the first and second simulation values M1, M2 are close to the actual measured value, the encoding unit 15 transmits the data that is only the current value I, the ambient temperature t, and each difference value Q, and applies entropy encoding. Hence, the amount of encoded data becomes quite little. In addition, the encoding unit 15 allocates a short coding length to a small value, and does not output data when the data on the characteristic parameter P is the same as that of the last data. Hence, the amount of data is reduced.

In addition, according to the third embodiment, when the amount of encoded data becomes equal to or greater than the threshold, and the simulation result becomes different from the actual measured value, the encoding unit 15 outputs the detection trigger R to the characteristic parameter detecting unit 12 to detect again the characteristic parameter P. In addition, the characteristic parameter detecting unit 12 according to the third embodiment detects the plurality of characteristic parameters P. Hence, according to such third embodiment, the data that precisely reflects the behavior of the battery cell 20 can be obtained.

Still further, with a short coding length being allocated to a small value, when the first simulation value M1 becomes greater than the predetermined value, the coding length by entropy encoding remarkably increases. Hence, according to the third embodiment, when the first simulation value M1 becomes greater than the predetermined value, the encoding process on the characteristic parameter P is changed from the entropy encoding to a simple binary number conversion. According to such a third embodiment, a remarkable increase in coding length can be avoided, maintaining a little data amount.

### (6) Fourth Embodiment

### [Structure]

The fourth embodiment is a modified example of the utilization-record-data obtaining block 1 in the third embodiment, and the basic structure is the same as that of the third embodiment. Hence, the same structural component as that of the third embodiment will be denoted by the same reference numeral, and the explanation thereof will be omitted.

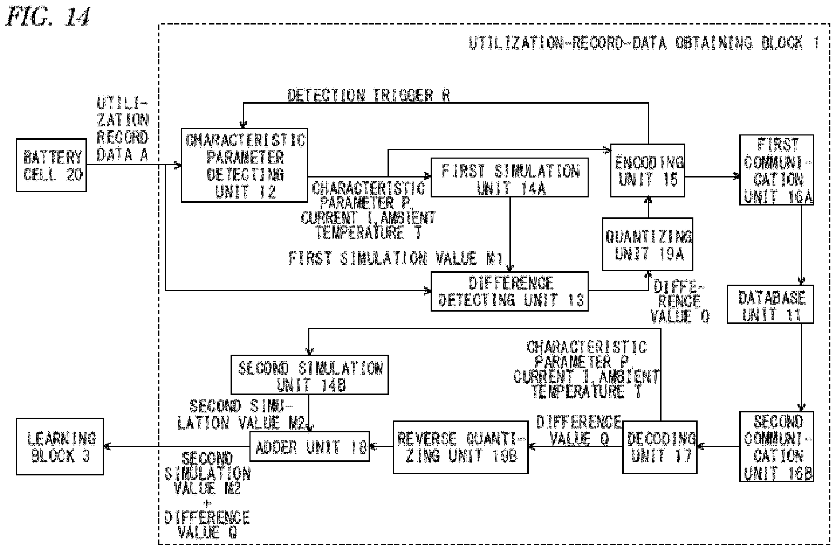

As illustrated in FIG. 14, according to the fourth embodiment, the difference detecting unit 13 is connected to a quantizing unit 19A, and the decoding unit 17 is connected to a reverse quantizing unit 19B. The quantizing unit 19A quantizes the difference value before the encoding, and calculates a quantized difference value. The reverse quantizing unit 19B performs reverse quantization on the decoded quantized difference value. The quantization is a division by a certain constant value, while the reverse quantization is a multiplication by a certain constant value oppositely. Consequently, the value is rounded. When, for example, the quantization is performed by 5, the values 1, 2, 3, 4 become 0, and still remains 0 even if the reverse decoding is performed.

### [Data Process by Utilization-record-data Obtaining Block]

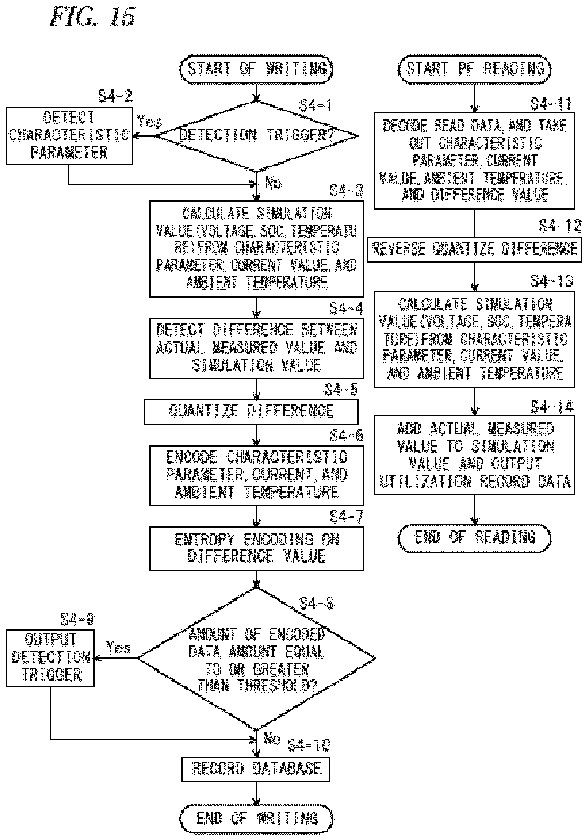

An explanation will be given of a data process according to the fourth embodiment with reference to the flowchart that is FIG. 15. The data process according to this embodiment is basically the same as the data process in the third embodiment illustrated in FIG. 13, but is characteristic in performing in quantization of the difference value Q and reverse quantization thereof (S4-5, S4-12). Other steps are the same as those in FIG. 13.

That is, according to the fourth embodiment, the quantizing unit 19A quantizes the difference value before encoded (S4-5), calculates the quantized difference value, and outputs the calculated result to the encoding unit 15. The encoding unit 15 performs entropy encoding on the quantized difference value (S4-7). In addition, the decoding unit 17 decodes the quantized difference value, and outputs this decoded value to the reverse quantizing unit 19B. The reverse quantizing unit 19B performs reverse quantization, and detects the difference value (S4-11).

### [Action and Effect]

According to the above fourth embodiment, the quantizing unit 19A quantizes the difference value before being encoded, and thus the writing information to the database unit 11 is omitted, thereby reducing the data amount. On the other hand, according to the fourth embodiment, since the types of encoding are reduced, the coding length is also remarkably reduced. In this embodiment, since a irreversible encoding is applied, the original value cannot be completely reproduced, but the amount of data as for the utilization record data A can be remarkably reduced.

### (7) Fifth Embodiment

### [Structure]

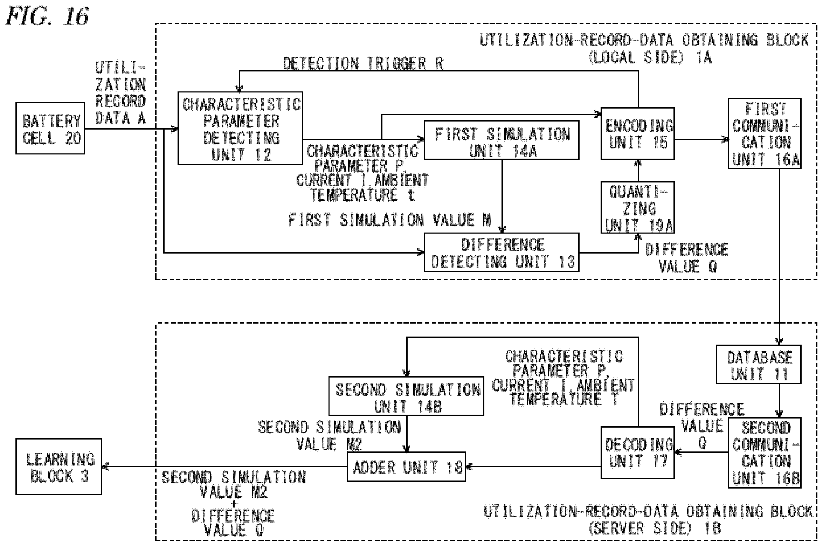

As illustrated in FIG. 16, according to a fifth embodiment, the structural component of the utilization-record-data obtaining block 1 is divided into a utilization-record-data obtaining block 1A at the local side, and a utilization-record-data obtaining block 1B at the server side. The local-side utilization-record-data obtaining block 1A includes the characteristic parameter detecting unit 12, the difference detecting unit 13, the first simulation unit 14A, the encoding unit 15, the first communication unit 16A, and the quantizing unit 19A.

The first communication unit 16A transmits data to a remote server by wired or wireless communication. In addition, the server-side utilization-record-data obtaining block 1B includes the database unit 11, the second communication unit 16B, the decoding unit 17, the second simulation unit 14B, the adder unit 18, and the reverse quantizing unit 19B.

### [Action and Effect]

According to the above fifth embodiment, the server-side utilization-record-data obtaining block 1B is provided with the database unit 11. Hence, a large-capacity data server is applicable to the database unit 11 at the server side, and a large amount of utilization record data A can be recorded. Hence, the utilization record data A to be communicated between the local side and the server side when, for example, the deterioration diagnoses on the large number of battery systems are statically processed at the server side, is remarkably reduced.

### (8) Sixth Embodiment

### [Structure]

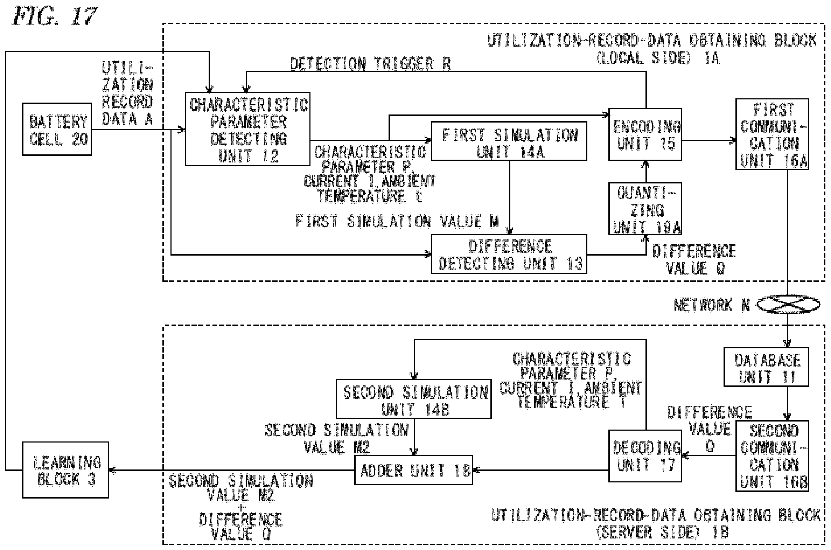

A sixth embodiment as illustrated in FIG. 17 is a modified example of the fifth embodiment, and has characteristic features such that the characteristic parameter detecting unit 12 in the local-side utilization-record-data obtaining block 1A obtains the deterioration rate table T from the learning block 3 as the learnt result.

### [Data Process by Utilization-record-data Obtaining Block]

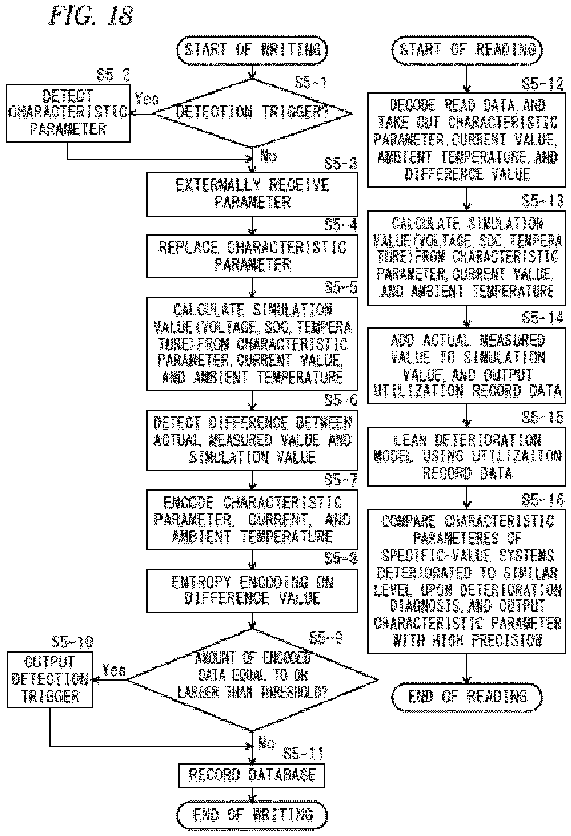

A data process according to the sixth embodiment is illustrated in the flowchart that is FIG. 18. The data process according to the sixth embodiment is basically the same as that of the third embodiment, but as indicated at S5-3 in FIG. 18, the characteristic parameter detecting unit 12 determines whether or not the characteristic parameter P is transmitted from the server-side utilization-record-data obtaining block 1B, and when receiving the characteristic parameter P from the server-side utilization-record-data obtaining block 1B (S5-3), the parameter is replaced with the characteristic parameter P at the local-side utilization-record-data obtaining block 1A (S5-4). Hereafter, this replaced characteristic parameter P is applied. Steps from S5-5 to S5-14 in FIG. 18 are the same as the steps from S3-3 to S3-12 in FIG. 13.

In the step S5-15, the information on the large number of battery systems is collected at the server side, and the deterioration model is learnt by the learning block 3 using the utilization record data A. Next, the characteristic parameters P of the battery systems, that are deteriorated to the similar level, are compared with each other based on the deterioration rate table T that is the learnt result by the learning block 3, a statistical process is performed, and a highly precise characteristic parameter P is output (S5-16).

### [Action and Effect]

According to the above sixth embodiment, not only the detected value of the characteristic parameter P detected at the local side but also the value of the characteristic parameter P transmitted from the utilization-record-data obtaining block 1B at the external server side are available as the value of the characteristic parameter P for the local-side utilization-record-data obtaining block 1A. Hence, the amount of the utilization record data A at the local side can be remarkably reduced.

### (9) Seventh Embodiment

Seventh to ninth embodiments have one of the features in the structure of the learning instruction block 2. The learning instruction block 2 is one of the three blocks which are roughly divided in the deterioration control device 10.

In the seventh to ninth embodiments, the structure other than the learning instruction block 2 is the same as that of the first embodiment, and the explanation thereof will be omitted.

### [Structure]

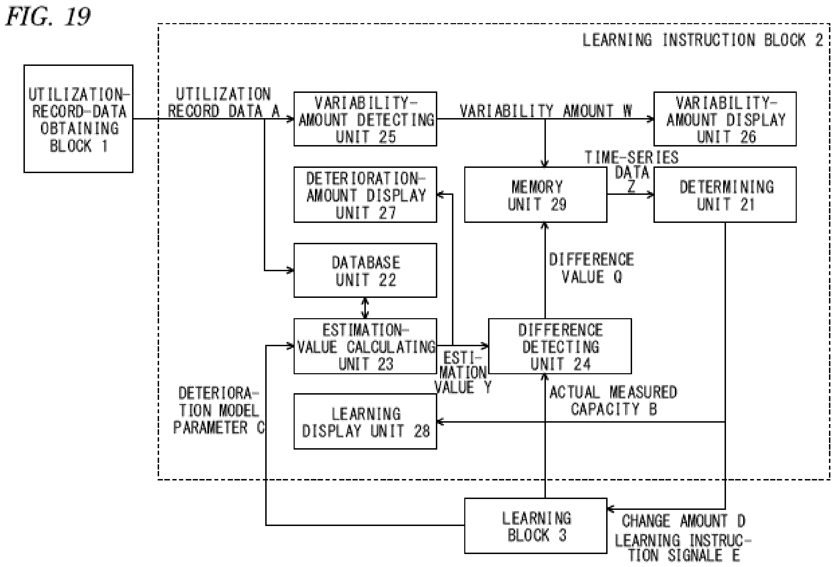

As illustrated in FIG. 19, the learning instruction block 2 according to the seventh embodiment includes, in addition to the determining unit 21 and the estimation-value calculating unit 23 explained in the paragraphs [0030], [0031], respectively, a database unit 22, an estimation-value difference detecting unit 24, a variability-amount detecting unit 25, a variability-amount display unit 26, a deterioration-amount display unit 27, a learning display unit 28, and a memory unit 29.

The memory unit 29 stores time-series data Z. The time-series data Z is a combination of the difference value Q detected by the estimation-value difference detecting unit 24, and a variability amount W detected by the variability-amount detecting unit 25. The determining unit 21 analyzes the time-series data Z, and outputs the learning instruction signal E to the learning block 3 when determining that the trend of this time-series data Z as non-linear.

The determining unit 21 determines whether or not to learn the deterioration rate table T as explained above, but the determining unit 21 according to the seventh embodiment eliminates an effect of a change in actual measured value due to the variability in the deterioration state of the battery cell 20, and determines whether or not to learn. That is, the determining unit 21 determines whether or not the correlation between the difference value Q and the variability amount W is non-linear, thereby eliminating the effect of a change in utilization record data A due to the variability amount W. In addition, the determining unit 21 is capable of adjusting a distribution width β that is a reference to determine whether or not the trend of the time-series data Z is non-linear.

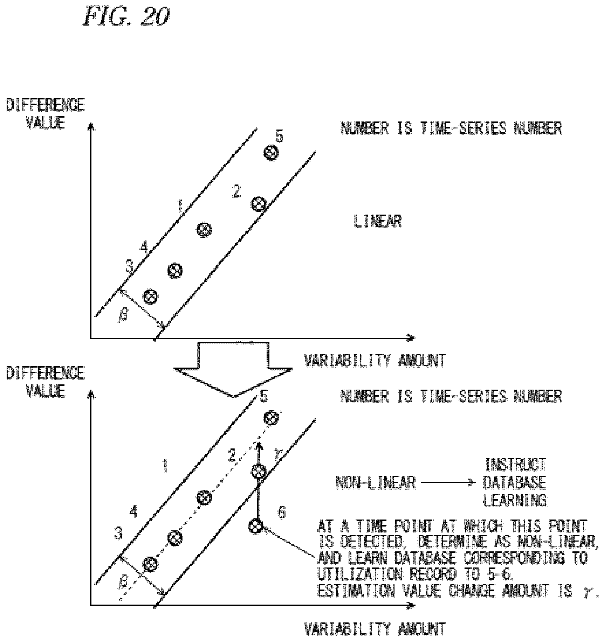

An explanation will be given of the distribution width β for the time-series data Z and the determination by the determining unit 21 on the non-linearity with reference to FIG. 20. When the time-series data Z are accumulated in the memory unit 29 to some amount, the pieces of time-series data Z show a certain tendency. In FIG. 20, circled numbers from 1 to 6 indicate the number of time-series data Z. The determining unit 21 determines the value of the distribution width β based on the tendency indicated by the time-series data Z.

The value of the distribution width β is a necessary coefficient for the determining unit 21 to determine that the time-series data Z are distributed linearly. When the value of the distribution width β is small, the correlation between the variability amount W and the difference value Q is strong. In this case, since the time-series data Z is likely to be out of the distribution width β, facilitating the determining unit 21 to determine that the trend of the time-series data Z is non-linear. In other words, it becomes unlikely for the determining unit 21 to determine that the trend of the time-series data Z is linear, and consequently outputting the learning instruction signal E to the learning block 3 frequently .

Conversely, when the value of the distribution width β is large, the correlation between the variability amount W and the difference value Q is not strong. In this case, the time-series data Z is not likely to be out of the distribution width β, making it unlikely for the determining unit 21 to determine that the trend of the time-series data Z is non-linear. In other words, it becomes easy for the determining unit 21 to determine that the trend of the time-series data Z is linear, and the output frequency of the learning instruction signal E to the learning block 3 decreases. Hence, the determining unit 21 adjusts the value of the distribution width β, thereby controlling the learning speed based on the output frequency of the learning instruction signal, and the deterioration control accuracy.

The determining unit 21 adjusts the value of the distribution width β in accordance with the situation, etc., of the battery system. For example, in the upper part of FIG. 20, the distribution width β is defined by the time-series numbers 1-5. This is an example case in which the distribution width β is set to take the variability amounts W of the first five points as a reference beforehand.

The distribution width β can be changed in accordance with the type and the characteristic of the battery cell 20 . In the lower part of FIG. 20, data that has the time-series number 6 is out of the linear region. At this time, the determining unit 21 outputs the learning instruction signal E to the learning block 3. Next, when the learning block 3 learns the deterioration rate table T, an estimation value γ for the capacity deterioration amount in the battery cell 20 is adjusted in a way that the difference value Q at the time-series number 6 to be in the center value within the linear region. This value γ is a distance between the center value of the distribution width β determined as linear and the difference value Q.

The estimation-value calculating unit 23 calculates the estimation value γ for the capacity deterioration amount in the battery cell 20. In the estimation-value calculating unit 23 of the first embodiment, since the estimation value for the calculated capacity deterioration amount is transmitted to the learning block 3 and applied to update the deterioration rate table T, therefore referred to as the change amount D. In the seventh embodiment, however, this value is directly referred to as the estimation value γ.

The estimation-value difference detecting unit 24 detects the difference value Q between the calculated estimation value γ by the estimation-value calculating unit 23 and the actual measured value that is the utilization record data A on the battery cell 20. When, for example, the actual measured value of the battery cell 20 is the capacity value, the capacity value from the full discharge to full charge becomes the actual measured capacity value. Alternatively, the capacity value from full charge to full discharge may be taken as the actual measured capacity value.

The estimation-value difference detecting unit 24 has the actual measured capacity value that is an actual measured capacity B input from the learning block 3. Both of the actual measured capacity value up to the full charge and the actual measured capacity value down to the complete discharge may be applied as the measured capacity value, but in view of the minimization of the deterioration amount when the capacity value is measured, it is desirable to measure, at least one time, both the actual measured capacity value by charging and the actual measured capacity value by discharging to calculate the respective deterioration amounts, and adopt the actual measured capacity value that has a smaller deterioration amount.

The variability-amount detecting unit 25 detects the variability amount W of when the deterioration state of the battery cell 20 is considered from the entire battery system, and the variability-amount display unit 26 displays the variability amount W on a monitor such as a display. The followings are example variability amounts W.

1. A difference in the maximum voltage value between the battery cells and the minimum value therebetween.
2. A difference in the maximum SOC between the battery cells and the minimum SOC value therebetween.
3. A difference between the maximum temperature value between the battery cells and the minimum temperature value therebetween.
4. A value depending on any of the above differences.
5. A standard deviation indicating the distribution of the voltage values in the battery system.
6. A standard deviation indicating the distribution of the SOC value in the battery system.
7. A standard deviation indicating the distribution of the temperature value in the battery system.

The database unit 22 stores the utilization record data A and constructs a database. The deterioration-amount display unit 27 displays the calculated deterioration amount by the estimation-value calculating unit 23 on a monitor such as a display. When the determining unit 21 outputs the learning instruction signal E, the learning display unit 28 indicates, to the external environment by LEDs, etc., an execution of the learning process.

### [Data Process by Learning Instruction Block]

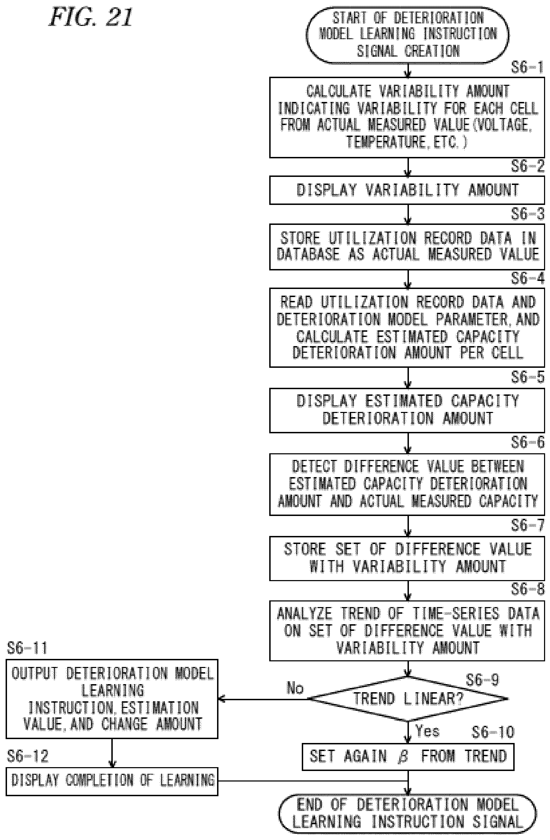

An explanation will be given of a data process according to the seventh embodiment with reference to the flowchart that is FIG. 21. The variability-amount detecting unit 25 has both the actual measured value of the battery cell 20 and the actual measured value of the entire battery system input from the external environment of the learning instruction block 2, and detects the variability amount W of the battery cell 20 from those actual measured values (S6-1). The variability-amount display unit 26 displays the variability amount W on the monitor (S6-2). In this case, the variability amount W indicates the variability amount of the entire battery system with respect to a given deterioration model parameter C.

The database unit 27 stores the utilization record data A that is the actual measured value of the battery cell 20 (S6-3). The utilization record data A is an actual measured value of each battery cell 20 during the utilization, and is the voltage value, the temperature value, the current value, and the SOC value, etc. The estimation-value calculating unit 23 reads the deterioration model parameter C from the learning block 3, reads the utilization record data A from the database unit 27, and calculates the estimation value γ for the deterioration amount per the battery cell 20 based on those data and an suitable function (S6-4). The deterioration-amount display unit 27 displays the estimation value γ for the deterioration amount (S6-5).

The estimation-value difference detecting unit 24 detects the difference value Q between the estimation value γ for the deterioration amount calculated by the estimation-amount calculating unit 23 and the actual measured value of the entire battery system (S6-6). The memory unit 29 stores the time-series data Z that is the set of the difference value Q and the variability amount W (S6-7). The determining unit 21 uses this time-series data Z, and determines in what condition of variability amount W did the measurement for the actual measured value of the entire battery system was made.

The actual measured value of the entire battery system is affected by the deterioration state of each battery cell 20, and also changes when, in principle, the deterioration state of each battery cell 20 varies. The change in actual measured capacity value due to the variability for each battery cell 20 is not irreversible, but temporal. Hence, when the effect by the change in capacity of the entire battery system due to the variability in the deterioration state of the battery cell 20 is eliminated, the remaining change amount is a true difference between two values that is the estimation value and the actual measured value.

The determining unit 21 analyzes the trend of the time-series data Z that is the set of the difference value Q and the variability amount W (S6-8). Next, the determining unit 21 determines whether or not the trend of the time-series data Z is linear (S6-9), and when determining that the trend of the time-series data Z is linear (S6-9: YES), the determining unit 21 sets again the value of the distribution width β based on the trend of the time-series data Z (S6-10).

On the other hand, when the trend of the time-series data Z is non-linear (S6-9: NO), the learning instruction signal E and the estimation value γ for the capacity deterioration amount (the change amount D in the first embodiment) are output to the learning block 3 (S6-11). When the determining unit 21 outputs the learning instruction signal E, the learning display unit 28 displays the execution of the learning process to the external environment (S6-12).

### [Action and Effect]

According to the above seventh embodiment, the determining unit 21 outputs the learning instruction signal E to the learning block 3, with an effect of the changes of the actual measured value due to the variability in the deterioration state of the battery cell 20 being eliminated, and the learning block 3 is capable of learning the deterioration model high accuracy. Hence, even if the capacity measured from the entire battery system is adopted, an excellent deterioration model can be constructed without an effect due to the variability in the deterioration state of the battery cell 20.

In addition, the determining unit 21 may have a threshold α determined beforehand based on tests, and may output the learning instruction signal E to the learning block 3 when the detected difference value Q by the estimation-value difference detecting unit 24 is equal to or greater than the threshold α. By this, the determining unit 21 is capable of efficiently outputting the learning instruction signal E. In addition, according to the seventh embodiment, since the display units, such as the variability-amount display unit 26, the deterioration amount display 27, and the learning display unit 28, display the data and the process to the external environment, and the work efficiency along with the deterioration control can be improved.

### (10) Eighth Embodiment

### [Structure]

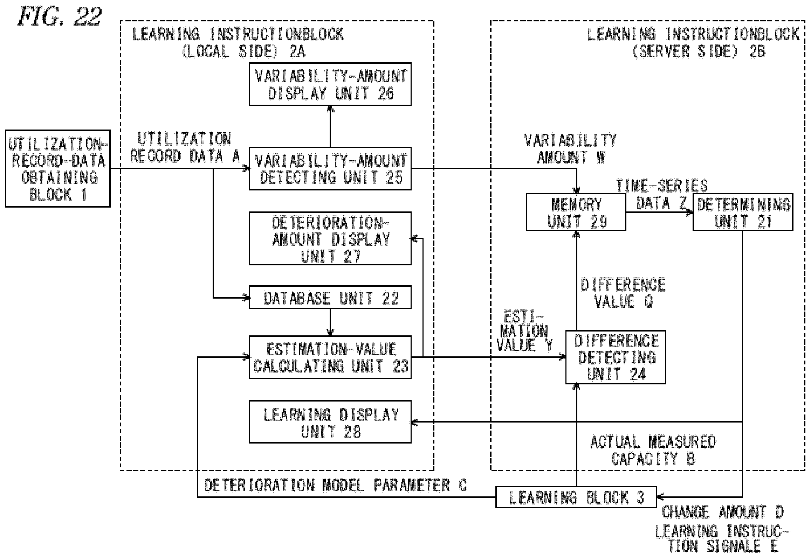

An eighth embodiment basically employs the same structure as that of the seventh embodiment. Hence, the same structural component as that of the seventh embodiment will be denoted by the same reference numeral, and the explanation thereof will be omitted. In the seventh embodiment, all structural components of the learning instruction block 2 are provided at the local side, but in the eighth embodiment illustrated in FIG. 22, the learning instruction block 2 includes a learning instruction block 2A at the local side, and a learning instruction block 2B at the server side.

The local-side learning instruction block 2A includes the database unit 22, the estimation-value calculating unit 23, the variability-amount detecting unit 25, the variability-amount display unit 26, the deterioration-amount display unit 27, and the learning display unit 28. In contrast, the server-side learning instruction block 2B includes the determining unit 21, the estimation-value difference detecting unit 24, and the memory unit 29. Those learning instruction blocks 2A, 2B are connected together by wired or wireless communication means (unillustrated).

### [Data Process by Learning Instruction Block]

In the eighth embodiment, the local-side learning instruction block 2A transmits a set of the variability amount W and the estimation value γ for the capacity deterioration amount to the server-side learning instruction block 2B via wired or wireless communication means, and the server-side learning block 2B transmits a set of the learning instruction signal E and the change amount D in estimation value to the local-side learning block 3 via wired or wireless communication means.

According to such eighth embodiment, when the correlation between the variability amount W and the difference value Q is analyzed, not only the result from a single battery system but also the trends at the other battery system employing the similar structure can be analyzed. Hence, the number of data sets increases, enabling a setting of the distribution width β and the estimation value γ for the capacity deterioration amount more suitable for the battery system. This further improves the deterioration control accuracy.

Depending on the installation environment of the battery system, there may be a battery system that is likely to cause a variability, and a battery system that is not likely to cause the variability. In this case, the reliability for each battery system can be set as appropriate. That is, for the battery system that shows a tendency of a little variability amount W, the reliability of the data set of the variability amount W and the difference value Q is set to high, while for the battery system that shows a tendency of a large variability amount W, the reliability is set to low. In addition, the distribution width β and the estimation value γ may be set preferentially using the data set with the high reliability, enabling an efficient learning of the deterioration rate table T.

### (11) Ninth Embodiment

### [Structure]

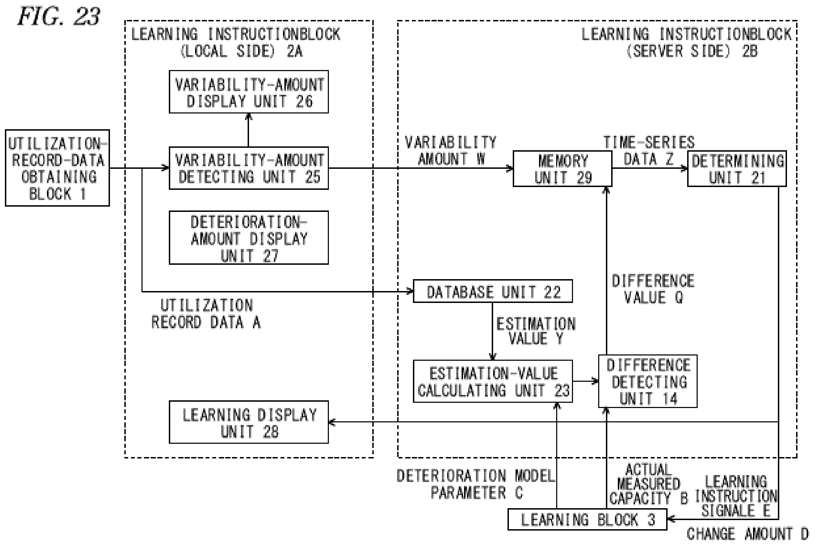

Like the eighth embodiment, in a ninth embodiment, the learning instruction block 2 is also divided and disposed at the local side and at the server side, and the basic structure is the same as that of the seventh embodiment. Hence, the same structural component as that of the seventh embodiment will be denoted by the same reference numeral, and the explanation thereof will be omitted. As illustrated in FIG. 23, according to the learning instruction block 2 of the ninth embodiment, the variability-amount detecting unit 25, the variability-amount display unit 26, the deterioration-amount display unit 27, and the learning display unit 28 are provided at the local side, while the other structural components are provided at the server side.

### [Action and Effect]

According to the ninth embodiment, in addition to the actions and effects of the above eighth embodiment, since the database unit 22 is provided at the server side, unique action and effect such as the memory capacity to store the utilization record data A, etc., at the local side can be reduced, can be achieved.

### (12) Other Embodiments

The above embodiments are merely presented as examples in this specification, and are not intended to limit the scope of the present disclosure. The present disclosure can be carried out in other various forms, and various omissions, replacements, and modifications can be made thereto without departing from the scope of the present disclosure. Those embodiments and modified forms thereof are within the scope of the invention as recited in appended claims.

For example, the specific details of the information and the numerical value thereof are optional in the above embodiments, and are not limited to particular details and numerical value. In the embodiments, as for the large and small determination and the matching and mismatching determination relative to a threshold, it is also optional to make a determination based on references like equal to or greater than and equal to or smaller than including the value, or like greater than, smaller than, exceeding, and below excluding the value. Hence, there is no substantial difference when, for example, the references "equal to or greater than" and "equal to or smaller than" are considered as "greater than" and "smaller than", respectively, depending on the setting of the value.

### REFERENCE SIGNS LIST

1, 1A, 1BUtilization-record-data obtaining block
2, 2A, 2B Learning instruction block
3, 3A, 3B Learning block
10 Deterioration control device
11, 22 Database unit
12 Characteristic parameter detecting unit
13 Difference detecting unit
14A First simulation unit
14B Second simulation unit
15 Encoding unit
16A First communication unit
16B Second communication unit
17 Decoding unit
18 Adder unit
19A Quantizing unit
19B Reverse quantizing unit
20 Battery cell
21 Determining unit
23 Estimation-value calculating unit
24 Estimation-value difference detecting unit
25 Variability-amount detecting unit
26 Variability-amount display unit
27 Deterioration-amount display unit
28 Learning display unit
29 Memory unit
30 Charging-and-discharging control device
31 Current integrating unit
32 Constant-current-capacity detecting unit
33 Constant-voltage-capacity detecting unit
34 Deterioration-rate-table learning unit
35 Deterioration-rate-table memory unit
36 Deterioration-rate-table calculating unit
A Utilization record data
B Actual measured value
C Deterioration model parameter
D Change amount
E Learning instruction signal
F Charging and discharging instruction
G1, G2 Detection signal
P Characteristic parameter
Q Difference value
T Deterioration rate table
T1 Capacity value table
T2 Internal resistance value table
W Variability amount
Z Time-series data
γ Estimation value for the capacity deterioration amount

## Claims

1. A deterioration control device for a battery system comprising a plurality of battery cells and a charging and discharging control device controlling charging and discharging of the battery cells, the deterioration control device comprising:
a utilization-record-data obtaining block configured to obtain utilization record data of the battery cell;
a learning block configured to update an amount of data on a deterioration model parameter that indicates a deterioration state of the battery cell based on the utilization record data, to update the deterioration model parameter, and to output an updated result that is a deterioration rate table to the charging and discharging control device; and
a learning instruction block configured to compare the utilization record data with an estimation value, to determine whether or not the deterioration model parameter is learnt, and to output a learning instruction signal to the learning block, while at the same time to calculate a change amount in the deterioration model parameter for the battery cell, and to output the change amount to the learning block;
wherein the learning block comprises:
a constant-current-capacity calculating unit configured to calculate a constant-current capacity value obtained by charging or discharging until a specific voltage at a constant current;
a constant-voltage-capacity calculating unit configured to calculate a constant-voltage capacity value by outputting signals of charging and discharging the battery cell with the constant current until reaching the constant voltage, outputting signals of charging and discharging again the battery cell with a constant current which has a current value smaller than the constant current until reaching the constant voltage, repeating the output of said signals until the current value reaches a certain value, and integrating capacity values up to until the current value reached the certain value; and
a current-capacity set calculating unit configured to calculate a set of the current value when the constant-voltage capacity value is obtained and the constant-voltage capacity value.

2. The deterioration control device according to claim 1, wherein the learning block comprises a deterioration-rate-table calculating unit configured to a capacity value table based on the constant-current capacity value, and an internal resistance value table based on the constant-voltage capacity value.

3. The deterioration control device according to claim 2, wherein the deterioration-rate-table calculating unit compares the tables with each other in accordance with a preset determination reference, and classifies the internal resistance value table into a plurality of groups.

4. The deterioration control device according to claim 3, wherein the deterioration-rate-table calculating unit compares the tables for an SOC direction that has a determination factor which is a remaining level of the battery cell, and for a temperature direction that has a determination factor which is a temperature.

5. The deterioration control device according to claim 3 or 4, wherein the deterioration-rate-table calculating unit is capable of specifying a number of the classification groups.

6. The deterioration control device according to any one of claims 3-5, wherein when there is a plurality of the internal resistance tables in the same classification group, the deterioration-rate-table calculating unit selects the internal resistance table that has a determination coefficient in a state of charge direction and a determination coefficient in a temperature direction at the center of the same classification group from the plurality of internal resistance tables within the same classification group.

7. The deterioration control device according to any one of claims 2-6, wherein the utilization-record-data obtaining block comprises:
a characteristic parameter detecting unit configured to detect a characteristic parameter of the battery cell;
a first simulation unit configured to simulate the deterioration state of the battery cell using the characteristic parameter, and calculating a first simulation value;
an actual value calculating unit configured to calculate an actual value of the deterioration state of the battery cell based on the utilization record data of the battery cell;
a difference detecting unit configured to detect a difference value between the first simulation value and the actual value;
an encoding unit configured to encode the difference value and the characteristic parameter;
a decoding unit configured to decode the encoded data by the encoding unit, and to read the difference value and the characteristic parameter;
a second simulation unit configured to simulate the deterioration state of the battery cell using the read characteristic parameter by the decoding unit, and to calculate a second simulation value; and
an adder unit configured to add the second simulation value with the decoded difference value.

8. The deterioration control device according to claim 7, further comprising a plurality of the characteristic parameter detecting units.

9. The deterioration control device according to claim 7 or 8, wherein when an amount of encoded data exceeds a threshold, the encoding unit outputs a detection trigger to the characteristic parameter detecting units to detect again the characteristic parameter.

10. The deterioration control device according to any one of claims 7-9, wherein the encoding unit performs entropy encoding on the difference value.

11. The deterioration control device according to claim 10, wherein the encoding unit allocates a short code to the small difference value to perform the entropy encoding.

12. The deterioration control device according to claim 11, wherein the encoding unit performs the entropy encoding only when the coding length becomes shorter in comparison with a case in which the entropy encoding is not performed.

13. The deterioration control device according to claim 12, wherein when the first simulation value becomes greater than a predetermined value, the encoding unit changes an encoding process on the characteristic parameter from the entropy encoding to a simple binary value conversion.

14. The deterioration control device according to claim 13, wherein:
the encoding unit performs quantization prior to the encoding, and encodes and outputs a threshold at the time of quantization; and
the decoding unit takes out the threshold at the time of decoding, performs reverse quantization after the decoding, and takes out the value.

15. The deterioration control device according to any one of claims 7-14, further comprising, in addition to the characteristic parameter detecting unit, a characteristic parameter outputting unit configured to output the characteristic parameter to the first simulation unit.

16. The deterioration control device according to any one of claims 2-15, wherein the learning instruction block comprises:
a variability-amount detecting unit configured to detect a variability amount of when the deterioration state of the battery cell is considered from a standpoint of the entire battery system;
an estimation-value calculating unit configured to calculate an estimation value of a deterioration amount of the battery cell;
an estimation-value difference detecting unit configured to detect a difference value between the calculated estimation value by the estimation-value calculating unit and an actual value of the battery cell; and
a determining unit configured to take a set of the difference value and the variability amount as time-series data, analyzing a correlation of the time-series data, and to determine whether a correlation between the variability amount and the difference value is linear or non-linear, and when determining that the correlation is non-linear, to output the learning instruction signal to the learning block.

17. The deterioration control device according to claim 16, wherein the actual value adopted for the estimation-value difference detecting unit is a capacity of the battery system up to a full charging after a complete discharging, or a capacity of the battery system down to a complete discharging after a full charging.

18. The deterioration control device according to claim 16 or 17, wherein when the difference value is equal to or greater than a preset threshold, the learning instruction block outputs the learning instruction signal to the learning block.

19. The deterioration control device according to claim 16, wherein when the correlation falls in a distribution width indicated by a preset threshold, the determining unit determines that the correlation is linear.

20. The deterioration control device according to any one of claims 16-19, further comprising a database unit configured to store the utilization record data,
wherein the database unit deletes the utilization record data used for learning after the learning block learns the deterioration estimation value.

21. The deterioration control device according to any one of claims 16-20, further comprising a display unit configured to display at least one of the actual value, the estimation value, a learnt result by the learning block, the difference value, the variability amount, and the time-series data.

22. A deterioration control method for a battery system, the method comprising:
a utilization-record-data obtaining step obtaining utilization record data of a battery cell;
a learning step updating an amount of data on a deterioration model parameter indicating the deterioration state of the battery cell based on the utilization record data to update the deterioration model parameter, and outputting an updated result that is a deterioration rate table; and
a learning instruction step comparing the utilization record data with an estimation value to determine whether or not the deterioration model parameter is learnt, outputting a learning instruction signal, while at the same time calculating a change amount in the deterioration model parameter, and outputting the change amount;
wherein the utilization-record-data obtaining step comprises:
a characteristic parameter detecting step detecting a characteristic parameter of the battery cell;
a first simulation step simulating the deterioration state of the battery cell using the characteristic parameter, and calculating a first simulation value;
an actual value calculating step calculating an actual value of the deterioration state of the battery cell based on the utilization record data on the battery cell;
a difference detecting step detecting a difference value between the first simulation value and the actual value;
an encoding step encoding the difference value and the characteristic parameter;
a decoding step decoding the encoded data, and reading the difference value and the characteristic parameter;
a second simulation step simulating the deterioration state of the battery cell using the characteristic parameter, and calculating a second simulation value; and
an adding step adding the second simulation value with the decoded difference value.

23. The deterioration control method according to claim 22, wherein the learning instruction step comprises:
a variability-amount detecting step detecting a variability amount when the deterioration state of the battery cell is considered from a standpoint of the entire battery system;
an estimation-value calculating step calculating an estimation value of a deterioration amount of the battery cell;
a difference value detecting step detecting a difference value between the calculated estimation value in the estimation-value calculating step and an actual value of the battery cell; and
a determining step taking a set of the difference value and the variability amount as time-series data, analyzing a correlation of the time-series data, and determining whether a correlation between the variability amount and the difference value is linear or non-linear.

## Patentansprüche

1. Abnutzungskontroll-Vorrichtung für ein Batteriesystem, umfassend eine Vielzahl von Batteriezellen und eine Lade- und Entladekontroll-Vorrichtung, die das Laden und Entladen der Batteriezellen kontrolliert, wobei die Abnutzungskontroll-Vorrichtung umfasst:
einen Block zum Erhalten von Nutzungs-Speicherdaten, der zum Erhalten von Nutzungsaufzeichnungs-Daten der Batteriezelle gestaltet ist;
einen Lernblock, der zum Aktualisieren einer Datenmenge auf einem Abnutzungsmodell-Parameter gestaltet ist, der einen Abnutzungszustand der Batteriezelle basierend auf den Nutzungsaufzeichnungs-Daten angibt, um die Abnutzungsmodell-Parameter zu aktualisieren und um ein aktualisiertes Ergebnis, das eine Abnutzungsraten-Tabelle ist, an die Lade- und Entladekontroll-Vorrichtung auszugeben; und
einen Lernanweisungs-Block, der zum Vergleichen der Nutzungsaufzeichnungs-Daten mit einem Schätzwert gestaltet ist, um zu bestimmen, ob der Abnutzungsmodell-Parameter gelernt ist oder nicht und um ein Lernanweisungs-Signal an den Lernblock auszugeben, um gleichzeitig eine Änderungsmenge in dem Abnutzungsmodell-Parameter für die Batteriezelle zu berechnen und um die Änderungsmenge an den Lernblock auszugeben;
wobei der Lernblock umfasst:
eine Berechnungseinheit der Konstantstrom-Kapazität, die gestaltet ist, um einen Konstantstrom-Kapazitätswert zu berechnen, der durch Laden oder Entladen bis zu einer spezifischen Spannung an einem Konstantstrom erhalten ist;
eine Berechnungseinheit einer Konstantspannungs-Kapazität, die zum Berechnen eines Konstantspannungs-Kapazitätswertes durch Ausgeben von Signalen des Ladens und Entladens der Batteriezelle mit dem Konstantstrom gestaltet ist, bis die Konstantspannung erreicht ist, erneutes Ausgeben von Signalen des Ladens und Entladens der Batteriezelle mit einem Konstantstrom, der einen kleineren Stromwert aufweist als der Konstantstrom, bis zum Erreichen der Konstantspannung, Wiederholen der Ausgabe der Signale, bis der Stromwert einen bestimmten Wert erreicht und Aufnehmen von Kapazitätswerten, bis der Stromwert den bestimmten Wert erreicht; und
eine Berechnungseinheit des Stromkapazitäts-Solls, die zum Berechnen eines Solls des Stromwertes, wenn der Konstantspannungs-Kapazitätswert erreicht ist und des Konstantspannungs-Kapazitätswertes gestaltet ist.

2. Abnutzungskontroll-Vorrichtung nach Anspruch 1, wobei der Lernblock eine Berechnungseinheit für die Abnutzungsraten-Tabelle, die basierend auf dem Konstantstrom-Kapazitätswert für eine Kapazitätswert-Tabelle gestaltet ist, und eine auf dem Konstantspannungs-Kapazitätswert basierende interne Widerstandswert-Tabelle umfasst.

3. Abnutzungskontroll-Vorrichtung nach Anspruch 2, wobei die Berechnungseinheit für die Abnutzungsraten-Tabelle die Tabellen mit jeder anderen gemäß einer voreingestellten Bestimmungsreferenz vergleicht und die interne Widerstandswert-Tabelle in eine Vielzahl von Gruppen klassifiziert.

4. Abnutzungskontroll-Vorrichtung nach Anspruch 3, wobei die Berechnungseinheit für die Abnutzungsraten-Tabelle die Tabellen für eine SOC-Richtung, die einen Bestimmungsfaktor aufweist, der ein verbleibendes Niveau der Batteriezelle ist, und für eine Temperaturrichtung, die einen Bestimmungsfaktor aufweist, der eine Temperatur ist, vergleicht.

5. Abnutzungskontroll-Vorrichtung nach Anspruch 3 oder 4, wobei die Berechnungseinheit für die Abnutzungsraten-Tabelle zum Spezifizieren einer Anzahl der Klassifizierungsgruppen in der Lage ist.

6. Abnutzungskontroll-Vorrichtung nach irgendeinem der Ansprüche 3-5, wobei, wenn es mehrere interne Widerstandstabellen in derselben Klassifizierungsgruppe gibt, die Berechnungseinheit für die Abnutzungsraten-Tabelle die interne Widerstandstabelle auswählt, die einen Bestimmungskoeffizienten in einem Status der Laderichtung und einen Bestimmungskoeffizienten in einer Temperaturrichtung am Zentrum derselben Klassifizierungsgruppe von den mehreren internen Widerstandstabellen innerhalb derselben Klassifizierungsgruppe aufweist.

7. Abnutzungskontroll-Vorrichtung nach irgendeinem der Ansprüche 2-6, wobei der Block zum Erhalten der Nutzungsaufzeichnungs-Daten umfasst:
eine Einheit zum Erkennen von charakteristischen Parametern, die zum Erkennen eines charakteristischen Parameters der Batteriezelle gestaltet ist;
eine erste Simulationseinheit, die zum Simulieren des Abnutzungsstatus der Batteriezelle unter Verwenden des charakteristischen Parameters und unter Berechnen eines ersten Simulationswertes gestaltet ist;
eine Berechnungseinheit des effektiven Wertes, die zum Berechnen eines effektiven Wertes des Abnutzungsstatus der Batteriezelle basierend auf den Nutzungsaufzeichnungs-Daten der Batteriezelle gestaltet ist;
eine Differenzerkennungs-Einheit, die zu Erkennen eines Differenzwertes zwischen dem ersten Simulationswert und dem effektiven Wert gestaltet ist;
eine Kodierungseinheit, die zum Kodieren des Differenzwertes und des charakteristischen Parameters gestaltet ist;
eine Kodierungseinheit, die zum Dekodieren der kodierten Daten durch die Kodierungseinheit und zum Lesen des Differenzwertes und des charakteristischen Parameters gestaltet ist;
eine zweite Simulationseinheit, die zum Simulieren des Abnutzungsstatus der Batteriezelle unter Verwenden des gelesenen charakteristischen Parameters durch die Dekodierungseinheit und zum Berechnen eines zweiten Simulationswertes gestaltet ist; und
eine Hinzufüge-Einheit, die zum Hinzufügen des zweiten Simulationswertes zu dem dekodierten Differenzwert gestaltet ist.

8. Abnutzungskontroll-Vorrichtung nach Anspruch 7, weiterhin umfassend mehrere Einheiten zum Erkennen von charakteristischen Parametern.

9. Abnutzungskontroll-Vorrichtung nach Anspruch 7 oder 8, wobei, wenn eine Menge von kodierten Daten einen Schwellenwert übersteigt, die Kodierungseinheit einen Erkennungsauslöser an die Einheiten zum Erkennen von charakteristischen Parametern ausgibt, um erneut den charakteristischen Parameter zu erkennen.

10. Abnutzungskontroll-Vorrichtung nach irgendeinem der Ansprüche 7-9, wobei die Kodierungseinheit eine auf dem Differenzwert kodierende Entropie durchführt.

11. Abnutzungskontroll-Vorrichtung nach Anspruch 10, wobei die Kodierungseinheit dem kleinen Differenzwert zum Durchführen der EntropieKodierung einen kurzen Code zuordnet.

12. Abnutzungskontroll-Vorrichtung nach Anspruch 11, wobei die Kodierungseinheit die Entropiekodierung nur dann durchführt, wenn die Kodierungslänge im Vergleich zu einem Fall, in dem die Entropiekodierung nicht durchgeführt ist, kürzer wird.

13. Abnutzungskontroll-Vorrichtung nach Anspruch 12, wobei, wenn der erste Simulationswert größer wird als ein vorbestimmter Wert, die Kodierungseinheit einen Kodierungsprozess auf dem charakteristischen Parameter von der Entropiekodierung in eine einfache binäre Wert-Umwandlung ändert.

14. Abnutzungskontroll-Vorrichtung nach Anspruch 13, wobei:
die Kodierungseinheit vor dem Kodieren eine Quantifizierung durchführt und einen Schwellenwert zum Zeitpunkt der Quantifizierung kodiert und ausgibt; und
die Dekodierungseinheit den Schwellenwert zum Zeitpunkt der Dekodierung herausnimmt nach dem Dekodieren eine Umkehr-Quantifizierung durchführt, und den Wert herausnimmt.

15. Abnutzungskontroll-Vorrichtung nach irgendeinem der Ansprüche 7-14, zusätzlich zu der Einheit zum Erkennen des charakteristischen Parameters weiterhin umfassend eine Ausgabeeinheit eines charakteristischen Parameters, die zum Ausgeben des charakteristischen Parameters zur ersten Simulationseinheit gestaltet ist.

16. Abnutzungskontroll-Vorrichtung nach irgendeinem der Ansprüche 2-15, wobei der Lernanweisungsblock umfasst:
eine Erkennungseinheit für die Variabilitätsmenge, die zum Erkennen einer Variabilitätsmenge gestaltet ist, wenn der Abnutzungsstatus der Batteriezelle von einem Standpunkt des gesamten Batteriesystems betrachtet ist;
eine Berechnungseinheit eines Schätzwertes, die zum Berechnen eines Schätzwertes einer Abnutzungsmenge der Batteriezelle gestaltet ist;
eine Erkennungseinheit einer Schätzwert-Differenz, die zum Erkennen eines Differenzwertes zwischen dem berechneten Schätzwert durch die Berechnungseinheit des Schätzwertes und eines effektiven Wertes der Batteriezelle gestaltet ist; und
eine Bestimmungseinheit, die zum Aufnehmen eines Solls des Differenzwertes und der Variabilitätsmenge als Zeitserien-Daten, die eine Korrelation der Zeitserien-Daten analysiert, und zum Bestimmen, ob eine Korrelation zwischen der Variabilitätsmenge und dem Differenzwert linear oder nicht linear ist und wenn sie bestimmt, dass die Korrelation nicht linear ist, zum Ausgeben des Lernanweisungs-Signals an den Lernblock gestaltet ist.

17. Abnutzungskontroll-Vorrichtung nach Anspruch 16, wobei der effektive Wert, der für die Erkennungseinheit der Schätzwertdifferenz eine Kapazität des Batteriesystems bis zu einem vollständigen Laden nach einem kompletten Entladen oder eine Kapazität des Batteriesystems ist, das nach einem vollständigen Laden bis zu einem kompletten Entladen heruntergefahren ist.

18. Abnutzungskontroll-Vorrichtung nach Anspruch 16 oder 17, wobei, wenn der Differenzwert gleich wie oder größer ist als ein voreingestellter Schwellenwert, der Lernanweisungs-Block das Lernanweisungssignal an den Lernblock ausgibt.

19. Abnutzungskontroll-Vorrichtung nach Anspruch 16, wobei, wenn die Korrelation in eine Verteilungsbreite fällt, die durch einen voreingestellten Schwellenwert angegeben ist, die Bestimmungseinheit bestimmt, dass die Korrelation linear ist.

20. Abnutzungskontroll-Vorrichtung nach irgendeinem der Ansprüche 16-19, weiterhin umfassend eine Datenbank-Einheit, die zum Speichern der Nutzungsaufzeichnungs-Daten gestaltet ist,
wobei die Datenbank-Einheit die Nutzungsaufzeichnungs-Daten löscht, die zum Lernen verwendet sind, nachdem der Lernblock den Abnutzungsschätzwert gelernt hat.

21. Abnutzungskontroll-Vorrichtung nach irgendeinem der Ansprüche 16-20, weiterhin umfassend eine Anzeige-Einheit, die zum Anzeigen wenigstens eines effektiven Wertes, des Schätzwertes, eines von dem Lernblock gelernten Ergebnisses, des Differenzwertes, der Variabilitätsmenge und der Zeitseriendaten gestaltet ist.

22. Abnutzungskontroll-Verfahren für ein Batteriesystem, wobei das Verfahren umfasst:
einen Schritt zum Erhalten von Nutzungsaufzeichnungs-Daten, der Nutzungsaufzeichnungs-Daten einer Batteriezelle erhält;
einen Lernschritt, der eine Datenmenge auf einem Abnutzungsmodell-Parameter aktualisiert, die den Abnutzungsstatus der Batteriezelle basierend auf den Abnutzungsaufzeichnungs-Daten angibt, um den Abnutzungsmodell-Parameter zu aktualisieren und ein aktualisiertes Ergebnis auszugeben, das eine Abnutzungsraten-Tabelle ist; und
einen Lernanweisungsschritt, der die Nutzungsaufzeichnungs-Daten mit einem Schätzwert vergleicht, um zu bestimmen, ob der Abnutzungsmodell-Parameter gelernt ist oder nicht, ein Lernanweisungssignal ausgibt, während er gleichzeitig eine Änderungsmenge in dem Abnutzungsmodell-Parameter berechnet und die Änderungsmenge ausgibt;
wobei der Schritt zum Erhalten von Nutzungsaufzeichnungs-Daten umfasst:
einen Schritt zum Erkennen charakteristischer Parameter, der einen charakteristischen Parameter der Batteriezelle erkennt;
einen ersten Simulationsschritt der den Abnutzungsstatus der Batteriezelle unter Verwenden des charakteristischen Parameters simuliert und einen ersten Simulationswert berechnet;
einen Berechnungsschritt des effektiven Wertes, der einen effektiven Wert des Abnutzungsstatus der Batteriezelle basierend auf den Nutzungsdaten auf der Batteriezelle berechnet;
einen Differenzerkennungs-Schritt, der einen Differenzwert zwischen dem ersten Simulationswert und dem effektiven Wert erkennt;
einen Kodierungsschritt, der den Differenzwert und den charakteristischen Parameter kodiert;
einen Dekodierungsschritt, der die kodierten Daten dekodiert und den Differenzwert und den charakteristischen Parameter liest;
einen zweiten Simulationsschritt, der den Abnutzungsstatus der Batteriezelle unter Verwenden des charakteristischen Parameters verwendet, und einen zweiten Simulationswert berechnet; und
einen Hinzufügeschritt der dem zweiten Simulationswert mit dem dekodierten Differenzwert hinzufügt.

23. Abnutzungskontroll-Verfahren nach Anspruch 22, wobei der Lernanweisungs-Schritt umfasst:
einen Schritt zum Erkennen der Variabilitätsmenge, der eine Variabilitätsmenge erkennt, wenn der Abnutzungsstatus der Batteriezelle von einem Standpunkt des gesamten Batteriesystems betrachtet ist;
einen Berechnungsschritt eines Schätzwertes, der einen Schätzwert einer Abnutzungsmenge der Batteriezelle berechnet;
einen Schritt zum Entdecken eines Differenzwertes, der einen Differenzwert zwischen dem berechneten Schätzwert in dem Berechnungsschritt eines Schätzwertes und einem effektiven Wert der Batteriezelle erkennt; und
einen Bestimmungsschritt, der ein Soll des Differenzwertes und der Variabilitätsmenge als Zeitserien-Daten aufnimmt, eine Korrelation der Zeitserien-Daten analysiert und bestimmt, ob eine Korrelation zwischen der Variabilitätsmenge und dem Differenzwert linear oder nicht linear ist.

## Revendications

1. Dispositif de contrôle de détérioration pour un système de pile comprenant une pluralité d'éléments de piles et un dispositif de commande de charge et décharge commandant la charge et la décharge des éléments de piles, le dispositif de contrôle de détérioration comprenant :
un bloc obtenant des données enregistrées d'utilisation configuré pour obtenir des données enregistrées d'utilisation de l'élément de pile;
un bloc d'apprentissage configuré pour mettre à jour une quantité de données sur un paramètre de modèle de détérioration qui indique un état de détérioration de l'élément de pile sur la base des données enregistrées d'utilisation, mettre à jour le paramètre de modèle de détérioration et émettre un résultat mis à jour qui est un tableau de taux de détérioration vers le dispositif de commande de charge et décharge; et
un bloc d'instruction d'apprentissage configuré pour comparer les données enregistrées d'utilisation avec une valeur d'estimation, déterminer si ou non le paramètre de modèle de détérioration est appris et émettre un signal d'instruction d'apprentissage vers le bloc d'apprentissage, tout en calculant simultanément une proportion de variation dans le paramètre de modèle de détérioration pour l'élément de pile, et émettre la proportion de variation vers le bloc d'apprentissage;
dans lequel le bloc d'apprentissage comprend :
une unité de calcul de capacité de courant constant configurée pour calculer une valeur de capacité de courant constant obtenue par charge et décharge jusqu'à une tension spécifique à un courant constant;
une unité de calcul de capacité de tension constante configurée pour calculer une valeur de capacité de tension constante en émettant des signaux de charge et décharge de l'élément de pile avec le courant constant jusqu'à ce que la tension constante soit atteinte, en émettant des signaux de charge et de décharge à nouveau de l'élément de pile avec un courant constant qui a une valeur de courant plus petite que le courant constant jusqu'à ce que la tension constante soit atteinte, en répétant l'émission desdits signaux jusqu'à ce que la valeur de courant atteigne une certaine valeur et en intégrant des valeurs de capacité jusqu'à ce que la valeur de courant ait atteint la certaine valeur; et
une unité de calcul de réglage de capacité de courant configurée pour calculer un réglage de la valeur de courant lorsque la valeur de capacité de tension constante est obtenue et de la valeur de capacité de tension constante.

2. Dispositif de contrôle de détérioration selon la revendication 1, dans lequel le bloc d'apprentissage comprend une unité de calcul de tableau de taux de détérioration configurée sur un tableau de valeurs de capacité basé sur la valeur de capacité de courant constant, et un tableau de valeur de résistance interne basé sur la valeur de capacité de tension constante.

3. Dispositif de contrôle de détérioration selon la revendication 2, dans lequel l'unité de calcul de tableau de taux de détérioration compare les tableaux les uns avec les autres conformément à une référence de détermination préréglée et classifie le tableau de valeur de résistance interne en une pluralité de groupes.

4. Dispositif de contrôle de détérioration selon la revendication 3, dans lequel l'unité de calcul de tableau de taux de détérioration comprend les tableaux pour une direction SOC qui a un facteur de détermination qui est un niveau restant de l'élément de pile, et pour une direction de température qui ab un facteur de détermination qui est une température.

5. Dispositif de contrôle de détérioration selon la revendication 3 ou 4, dans lequel l'unité de calcul de tableau de détérioration est capable de spécifier un nombre des groupes de classification.

6. Dispositif de contrôle de détérioration selon une quelconque des revendications 3-5, dans lequel lorsqu'il y a une pluralité de tableaux de résistance interne dans le même groupe de classification, l'unité de calcul de tableau de détérioration sélectionne le tableau de résistance interne qui a un coefficient de détermination dans un état de direction de charge et un coefficient de détermination dans une direction de température au centre du même groupe de classification d'après la pluralité de tableaux de résistance interne à l'intérieur du même groupe de classification.

7. Dispositif de contrôle de détérioration selon une quelconque des revendications 2-6, dans lequel le bloc d'obtention de données enregistrées d'utilisation comprend :
une unité de détection de paramètre caractéristique configurée pour détecter un paramètre caractéristique de l'élément de pile;
une première unité de simulation configurée pour simuler l'état de détérioration de l'élément de pile en utilisant le paramètre caractéristique et calculer une première valeur de simulation;
une unité de calcul de valeur effective configurée pour calculer une valeur effective de l'état de détérioration de l'élément de pile sur la base des données enregistrées d'utilisation de l'élément de pile;
une unité de détection de différence configurée pour détecter une valeur de différence entre la première valeur de simulation et la valeur effective;
une unité d'encodage configurée pour encoder la valeur de différence et le paramètre caractéristique;
une unité de décodage configurée pour décoder les données codées par l'unité d'encodage et lire la valeur de différence et le paramètre caractéristique;
une seconde unité de simulation configurée pour simuler l'état de détérioration de l'élément de pile en utilisant le paramètre caractéristique lu par l'unité de décodage, et calculer une seconde valeur de circulation; et
une unité de sommateur configurée pour additionner la seconde valeur de simulation avec la valeur de différence décodée.

8. Dispositif de contrôle de détérioration selon la revendication 7, comprenant en outre une pluralité des unités de détection de paramètre caractéristique.

9. Dispositif de contrôle de détérioration selon la revendication 7 ou 8, dans lequel lorsqu'une quantité des données codées excède un seuil, l'unité d'encodage émet un déclencheur de détection vers les unités de détection de paramètres caractéristiques pour détecter à nouveau le paramètre caractéristique.

10. Dispositif de contrôle de détérioration selon une quelconque des revendications 7-9, dans lequel l'unité d'encodage effectue un codage entropique sur la valeur de différence.

11. Dispositif de contrôle de détérioration selon la revendication 10, dans lequel l'unité d'encodage alloue un code court à la petite valeur de différence pour effectuer le codage entropique.

12. Dispositif de contrôle de détérioration selon la revendication 11, dans lequel l'unité d'encodage effectue le codage entropique seulement lorsque la longueur de codage devient plus courte comparé à un cas dans lequel le codage entropique n'est pas effectué.

13. Dispositif de contrôle de détérioration selon la revendication 12, dans lequel lorsque la première valeur de simulation devient supérieure à une valeur prédéterminée, l'unité d'encodage change un processus d'encodage sur le paramètre caractéristique du codage entropique à une conversion de valeur binaire simple.

14. Dispositif de contrôle de détérioration selon la revendication 13, dans lequel :
l'unité d'encodage effectue une quantification avant l'encodage, et code et émet un seuil au moment de la quantification ; et
l'unité de décodage extrait le seuil au moment du décodage, effectue une quantification inverse après le décodage et extrait la valeur.

15. Dispositif de contrôle de détérioration selon une quelconque des revendications 7-14, comprenant en outre, en plus de l'unité de détection de paramètre caractéristique, une unité d'émission de paramètre caractéristique configurée pour émettre le paramètre caractéristique vers la première unité de simulation.

16. Dispositif de contrôle de détérioration selon une quelconque des revendications 2-15, dans lequel le bloc d'instruction d'apprentissage comprend :
une unité de détection de proportion de variabilité configurée pour détecter une proportion de variabilité lorsque l'état de détérioration de l'élément de pile est considéré sous l'angle de la totalité du système de pile ;
une unité de calcul de valeur d'estimation configurée pour calculer une valeur d'estimation d'une proportion de détérioration de l'élément de pile ;
une unité de détection de différence de valeur d'estimation configurée pour détecter une valeur de différence entre la valeur d'estimation calculée par l'unité de calcul de valeur d'estimation et une valeur effective de l'élément de pile ; et
une unité de détermination configurée pour prendre un ensemble de la valeur de différence et la proportion de variabilité comme des données de séries temporelles, en analysant une corrélation de séries temporelles, et déterminer si une corrélation entre la proportion de variabilité et la valeur de différence est linéaire ou non linéaire, et lors de la détermination que la corrélation est non linéaire, émettre le signal d'instruction d'apprentissage vers le bloc d'apprentissage.

17. Dispositif de contrôle de détérioration selon la revendication 16, dans lequel la valeur effective adoptée pour l'unité de détection de différence de valeur d'estimation est une capacité du système de pile montant jusqu'à une charge complète après une décharge complète, ou une capacité du système de pile descendant jusqu'à une décharge complète après une charge complète.

18. Dispositif de contrôle de détérioration selon la revendication 16 ou 17, dans lequel lorsque la valeur de différence est égale ou supérieure à un seuil préréglé, le bloc d'instruction d'apprentissage émet le signal d'instruction d'apprentissage vers le bloc d'apprentissage.

19. Dispositif de contrôle de détérioration selon la revendication 16, dans lequel lorsque la corrélation baisse dans une largeur de distribution indiquée par un seuil préréglé, l'unité de détermination détermine que la corrélation est linéaire.

20. Dispositif de contrôle de détérioration selon une quelconque des revendications 16-19, comprenant en outre une unité de base de données configurée pour mémoriser les données enregistrées d'utilisation ;
dans lequel l'unité de base de données supprime les données enregistrées utilisation utilisées pour l'apprentissage après que le bloc d'apprentissage apprend la valeur d'estimation de détérioration.

21. Dispositif de contrôle de détérioration selon une quelconque des revendications 16-20, comprenant en outre l'unité d'affichage configurée pour afficher au moins une de la valeur effective, la valeur d'estimation, un résultat appris par le bloc d'apprentissage, la valeur de différence, la proportion de variabilité et les données de séries temporelles.

22. Procédé de contrôle de détérioration pour un système de pile, le procédé comprenant :
une étape d'obtention de données enregistrées d'utilisation obtenant des données enregistrées d'utilisation d'un élément de pile ;
une étape d'apprentissage mettant à jour une quantité de données sur un paramètre de modèle de détérioration indiquant l'état de détérioration de l'élément de pile sur la base des données enregistrées d'utilisation pour mettre à jour le paramètre de détérioration, et émettant un résultat mis à jour qui est un tableau de taux de détérioration ; et
une étape d'instruction d'apprentissage comprenant des données enregistrées d'utilisation avec une valeur d'estimation pour déterminer si ou non le paramètre de modèle de détérioration est appris, en émettant un signal d'instruction d'apprentissage, tout en calculant simultanément une proportion de variation dans le paramètre de modèle de détérioration et en émettant la proportion de variation ;
dans lequel l'étape d'obtention des données enregistrées d'utilisation comprend :
une étape de détection de paramètre caractéristique détectant un paramètre caractéristique de l'élément de pile ;
une première étape de simulation simulant l'état de détérioration de l'élément de pile en utilisant le paramètre caractéristique, et calculant une première valeur de simulation ;
une étape de calcul de valeur effective calculant une valeur effective de l'état de détérioration de l'élément de pile sur la base des données enregistrées d'utilisation sur l'élément de pile ;
une étape de détection de différence détectant une valeur de différence entre la première valeur de simulation et la valeur effective ;
une étape d'encodage codant la valeur de différence et le paramètre caractéristique ;
une étape de décodage décodant les données codées et lisant la valeur de différence de paramètre caractéristique ;
une seconde étape de simulation simulant l'état de détérioration de pile en utilisant le paramètre caractéristique, et calculant une seconde valeur de simulation ; et
une étape d'addition additionnant la seconde valeur de simulation avec la valeur de différence décodée.

23. Procédé de contrôle de détérioration selon la revendication 22, dans lequel l'étape d'instruction d'apprentissage comprend :
une étape de détection de proportion de variabilité détectant une proportion de variabilité lorsque l'état de détérioration de l'élément de pile est considéré sous l'angle de la totalité du système de pile ;
une étape de calcul de valeur d'estimation configurée pour calculer une valeur d'estimation d'une proportion de détérioration de l'élément de pile ;
une étape de détection de valeur de différence détectant une valeur de différence entre la valeur d'estimation calculée dans l'étape de calcul de valeur d'estimation et une valeur effective de l'élément de pile ; et
une étape de détermination configurée pour prendre un ensemble de la valeur de différence et la proportion de variabilité comme des données de séries temporelles, en analysant une corrélation de séries temporelles, et déterminer si une corrélation entre la proportion de variabilité et la valeur de différence et linéaire ou non linéaire.
